(19) **Europäisches Patentamt European Patent Office Office européen des brevets**

(11) **EP 4 738 702 A1**

(12) **EUROPEAN PATENT APPLICATION**

(43) Date of publication:
06.05.2026 Bulletin 2026/19

(21) Application number: 25208506.3

(22) Date of filing: 14.10.2025

(51) International Patent Classification (IPC):
*H03F 1/32* $^{(2006.01)}$       *H03F 3/189* $^{(2006.01)}$
*H03F 3/24* $^{(2006.01)}$

(52) Cooperative Patent Classification (CPC):
**H03F 1/3247; H03F 1/3258; H03F 3/189;**
**H03F 3/245;** H03F 2201/3209; H03F 2201/3224;
H03F 2201/3233

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: 30.10.2024 US 202418932222

(71) Applicant: **Avago Technologies International**
**Sales**
**Pte. Limited**
**Singapore 768923 (SG)**

(72) Inventors:
• **Sulimarski, Avi**
  **Irvine, CA, 92618 (US)**
• **Yaish, Israel**
  **Irvine, CA, 92618 (US)**

(74) Representative: **Grünecker Patent- und**
**Rechtsanwälte**
**PartG mbB**
**Leopoldstraße 4**
**80802 München (DE)**

(54) **PRE-DISTORTION SYSTEMS FOR A BAND LIMITED LOOPBACK**

(57) A digital pre-distortion achieving near ideal spectral regrowth suppression with a bandlimited loopback. To eliminate mismatch between the bandwidth of the pre-distortion model terms and the bandwidth of the signal used to determine the model a band limiting operation may be applied to both the loopback signal and the input to the power amplifier used for estimating the pre-distortion coefficients. In addition, oversampling may be performed in the digital domain to avoid aliasing in the nonlinear terms of the pre-distortion model.

FIG. 1A

**Description**

BACKGROUND

The present disclosure relates to pre-distortion used to compensate for nonlinearities in a power amplifier.

In certain applications accurate pre-distortion are necessary to suppress spectral regrowth and obtain optimal error vector magnitude (EVM). The digital pre-distortion feedback is often restricted by non-ideal components that limit bandwidth such as the anti-aliasing filter and the analog-to-digital converter sampling rate. Limited bandwidth can affect the capability of the pre-distortion technique making high throughput and wide band applications difficult, especially inexpensively and at usable distances.

BRIEF DESCRIPTION OF THE DRAWINGS

Various objects, aspects, features, and advantages of the disclosure will become more apparent and better understood by referring to the detailed description taken in conjunction with the accompanying drawings, in which like reference characters identify corresponding elements throughout. In the drawings, like reference numbers generally indicate identical, functionally similar, and/or structurally similar elements.

FIG. 1A is a block diagram depicting a network environment including one or more access points in communication with one or more devices or stations, according to some embodiments.

FIG. 1B is a block diagrams depicting computing devices useful in connection with the methods and systems described herein, according to some embodiments.

FIG. 1C is another block diagrams depicting computing devices useful in connection with the methods and systems described herein, according to some embodiments.

FIG. 2 is a block diagram of an amplifying device performing digital pre-distortion device, according to some embodiments.

FIG. 3 is a block diagram of the memory digital pre-distortion circuit of FIG. 2, according to some embodiments.

FIG. 4A is a block diagram of the model estimator circuit of FIG. 2, according to some embodiments.

FIG. 4B is a block diagram of the memory digital pre-distortion model circuit of FIG. 4A, according to some embodiments.

FIG. 5A is another block diagram of the model estimator circuit of FIG. 2, according to some embodiments.

FIG. 5B is a block diagram of the memory digital pre-distortion model circuit of FIG. 5A subject to a band limiting operation, according to some embodiments.

FIG. 6 is a flow diagram for performing digital pre-distortion using an upsampled digital loopback signal, according to some embodiments.

FIG. 7 is a flow diagram for performing digital pre-distortion by applying a band limiting operation to both the output of the digital pre-distortion model circuit and the input the power amplifier, according to some embodiments.

FIG. 8 is a flow diagram for performing digital pre-distortion by applying a band limiting operation to both the output of the digital pre-distortion model circuit and the input the power amplifier and upsampling a digital loopback signal, according to some embodiments

FIG. 9 is a plot of power as a function of frequency demonstrating improved adjacent channel power ratio (ACPR), according to some embodiments.

FIG. 10 is a plot of error vector magnitude (EVM) as a function of output power, according to some embodiments.

DETAILED DESCRIPTION

Some embodiments relate to a digital pre-distortion that achieves near ideal spectral regrowth suppression with a bandlimited loopback signal when compared to a loopback signal that has very wide bandwidth (e.g., would require expensive components to sample the analog-to-digital at a very fast rate). The systems and methods of the present disclosure are able to overcome issues related to the bandlimited loopback signal. To eliminate mismatch between the bandwidth of the pre-distortion model output and the bandwidth of the signal used to determine the model, a band limiting operation may be applied to both the loopback signal and the input to the power amplifier used for estimating the pre-distortion model. In addition, oversampling may be performed in the digital domain to avoid aliasing in the nonlinear terms of the model.

An embodiment relates to device including one or more circuits configured to perform operations. The operations include performing a digital pre-distortion of a signal. The operations include generating a digital loopback signal by sampling a loopback signal of an amplifier at a band limiting sampling frequency. The operations also include upsampling the digital loopback signal by interpolating between samples of the digital loopback signal. The operations also include estimating parameters of a digital pre-distortion model using the upsampled digital loopback signal.

Digital pre-distortion of a signal refers to applying an inverse operation (e.g., a canceling operation) to a signal prior to signal amplification where the inverse operation is designed to compensate for the effects of nonlinearities in the amplification process in some embodiments. For example, digital pre-distortion may refer to polynomial pre-distortion, memory digital pre-distortion, look-up table pre-distortion, etc. A loopback signal refers to a signal generated from the output of an amplifier that is used to estimate the model of a digital pre-distortion in some embodiments. For example, a loopback signal may refer to a signal split from the output of the amplifier. A sampling frequency refers to how many times a second the value of a signal is captured and recorded in some embodiments.

A band limiting sampling frequency refers to any sampling frequency that does not support full bandwidth of a sampled signal in some embodiments. For example, a band limiting sampling frequency of a loopback signal for an amplifier may refer to a sampling frequency that does not support (e.g., is not able to represent) the full spectral growth caused by the nonlinearities of the amplifier (e.g., a sampling frequency less than 3-5 times the bandwidth of the signal amplified, depending on the amplifier). Depending on the nonlinearities of the amplifier, a sampling frequency of a loopback signal for an amplifier less than or equal to the bandwidth of the signal amplified, less than or equal to two times the bandwidth of the signal amplified, less than or equal to three times the bandwidth of the signal amplified, etc. may be considered band limiting. The bandwidth of the signal refers to the range of frequences that a signal occupies in some embodiments. For example, a signal that includes frequency content between -160 MHz and 160 MHz may be referred to as having a bandwidth of 320 MHz. Upsampling a signal refers to adding samples between existing samples in the digital domain in some embodiments. For example, upsampling may refer to a process of obtaining a signal that has a sampling frequency of 500 MHz (e.g., 2 ns period) and adding a sample 1 ns after each existing sample using interpolation. Interpolating between samples refers to a technique of estimating the value of a signal at a given time between two known samples in some embodiments. For example, interpolation may refer to linear interpolation, polynomial interpolation, spline interpolation, trigonometric interpolation, etc. A pre-distortion model refers to the functions used to perform pre-distortion on a signal in some embodiments. For example, a pre-distortion model may refer to a neural network model (e.g., perceptron, transformer, etc.) or a Volterra series model.

In some embodiments, interpolating between samples is performed using at least one of linear interpolation, polynomial interpolation, spline interpolation, or trigonometric interpolation.

Linear interpolation refers to interpolating between samples using a line that passes through the two samples in some embodiments. Polynomial interpolation refers to interpolating between samples using a polynomial that passes through a number of points in some embodiments. For example, polynomial interpolation may refer to fitting a second order polynomial that passes through three points surrounding a new sampling point and evaluating the polynomial to determine the value at the new sampling point. Spline interpolation refers to interpolating between samples using a continuous spline of piecewise polynomials with continuous first and second derivatives that passes through a number of points surrounding a new sampling point according to some embodiments. For example, spline interpolation may refer to fitting data with cubic functions and evaluating the spline at the new sampling point. Trigonometric interpolation refers to interpolating between samples using a sum of trigonometric functions (e.g., sines, cosines, etc.) that passes through a number of points surrounding a new sampling point according to some embodiments. For example, trigonometric interpolation may refer to performing the discrete Fourier transform and using the resulting spectrum to determine the value at the new sampling point.

In some embodiments, the band limiting sampling frequency is less than or equal to two times a bandwidth of the signal and a sampling frequency of the upsampled digital loopback signal is at least two times the band limiting sampling frequency.

In some embodiments, the upsampled digital loopback signal reduces an aliasing effect of nonlinear terms of the digital pre-distortion model.

Aliasing of nonlinear terms refers to an effect, in some embodiments, where applying a nonlinear function to a sampled signal can generate new frequency components (e.g., harmonics) outside of the original signal's bandwidth (and greater than the Nyquist frequency) which are misrepresented by the sampled signal and can lead to distortion. For example, squaring a pure tone (e.g., sinusoid) results in a signal at twice the original frequency. Nonlinear terms refer to a portion of a function that does not satisfy superposition in some embodiments. For example, in $f(x, y) = x + 2y + x^2 + xy$, the terms $x^2$ and $xy$ are nonlinear terms.

In some embodiments, estimating the parameters of the digital pre-distortion model includes reducing error between an output of the digital pre-distortion and an output of the digital pre-distortion model using the upsampled digital loopback signal as input.

In some embodiments, the operations also include generating a band limited pre-distortion output signal by applying a band limiting operator to the output of the digital pre-distortion and generating an estimated band limited pre-distortion output signal by applying the band limiting operator to the output of the digital pre-distortion model using the upsampled digital loopback signal as input. Estimating the parameters of the digital pre-distortion model is performed by reducing error between the band limited pre-distortion output signal and the estimated band limited pre-distortion output signal.

In some embodiments, the digital pre-distortion model includes a Volterra series and the band limiting operator is applied to each of a set of monomial expansion terms of the Volterra series of the digital pre-distortion model.

A band limiting operator refers to a function that relates an output sample at a time to input samples at the time, sampling instances previous to the time, and sampling instance after the time (e.g., for a non-causal operator) and has the effect of liming the bandwidth of the output in some embodiments. For example, the band limiting operator may refer to an infinite impulse response (IIR) low pass filter (e.g., $y[k] = ax[k] + (1 - a)y[k - 1]$) or a finite impulse response (FIR) low pass filter (e.g., $y[k] = 0.5x[k] + 0.5x[k - 1]$). The Volterra series refers to a functional expansion of a dynamic, nonlinear, time-invariant system in some embodiments. For example, the Volterra series may refer to the expansion:

$$z[n] = \sum_{m=0}^{M_1} \sum_{p=0}^{P_1[m]} c_{m,p}^{(1)} x[n - m]|x[n - m]|^p \ldots$$

$$+ \sum_{k=1}^{K_2} \sum_{m=0}^{M_2[k]} \sum_{p=0}^{P_2[k,m]} c_{k,m,p}^{(2)} x[n - m]|x[n - m - k]|^p \ldots \quad equation\ 1$$

$$+ \sum_{k=1}^{K_3} \sum_{m=0}^{M_3[k]} \sum_{p=0}^{P_3[k,m]} c_{k,m,p}^{(3)} x[n - m - k]|x[n - m]|^p.$$

The monomial expansion terms refer to terms of the same type (e.g., same $p$ and $k$) in the Volterra series in some embodiments. For example, a monomial expansion term may refer to the terms:

$$\sum_{m=0}^{M_1} c_{m,1}^{(1)} x[n - m]|x[n - m]|. \quad equation\ 2$$

In some embodiments, a transmitter using the amplifier is not bandlimited between the amplifier and a coupler used to generate the loopback signal.

An embodiment relates to a device including one or more circuits configured to perform operations. The operations include performing a digital pre-distortion of a signal. The operations also include generating a digital loopback signal by sampling a loopback signal of an amplifier at a bandlimited sampling frequency. The operations also include generating a band limited pre-distortion output signal by applying a band limiting operator to an output of the digital pre-distortion. The operations also include estimating parameters of a digital pre-distortion model by reducing error between the band limited pre-distortion output signal and an output of the digital pre-distortion model using the digital loopback signal as input, wherein the band limiting operator is applied to each of a set of monomial expansion terms of the digital pre-distortion model.

In some embodiments, estimating the parameters of the digital pre-distortion model is performed using a least squares estimation technique.

Least squares estimation refers to a parameter fitting method where the goal is to minimize the squared error between the signal and the estimated value of the signal given the predictor variables in some embodiments. For example, least squares estimation may refer to linear regression. Least squares estimation may also refer to adaptive model estimation techniques, for example, recursive least squares (RLS) and/or least mean squares (LMS).

In some embodiments, the set of monomial expansion terms includes terms from a discrete Volterra series.

In some embodiments, a transmitter using the amplifier is not bandlimited between the amplifier and a coupler used to generate the loopback signal.

In some embodiments, the operations also include upsampling the digital loopback signal to reduce an aliasing effect of nonlinear terms of the digital pre-distortion model.

In some embodiments, the band limiting sampling frequency is less than or equal to two times a bandwidth of the signal and a sampling frequency of the upsampled digital loopback signal is at least two times the band limiting sampling frequency.

An embodiment relates to a device including one or more circuits configured to perform operations. The operations include performing a digital pre-distortion of a signal. The operations also include acquiring a digital loopback signal by sampling a loopback signal of an amplifier. The operations also include generating a band limited pre-distortion output signal by applying a band limiting operator to an output of the digital pre-distortion of the signal. The operations also include upsampling the digital loopback signal by interpolating between samples of the digital loopback signal. The operations also include generating an estimated band limited pre-distortion output signal by applying the band limiting operator to the output of a digital pre-distortion model using the upsampled digital loopback signal as input. The operations also include estimating parameters of the digital pre-distortion model by reducing error between the band limited pre-distortion output signal and the estimated band limited pre-distortion output signal.

In some embodiments, estimating the parameters of the digital pre-distortion model is performed using a least squares estimation technique.

In some embodiments, the digital pre-distortion model includes a set of monomial expansion terms and generating an estimated band limited pre-distortion output includes applying the band limiting operator to each of the set of monomial expansion terms.

In some embodiments applying the band limiting operator reduces frequencies outside a frequency band of the signal.

In some embodiments, interpolating between samples is performed using at least one of linear interpolation, polynomial interpolation, spline interpolation, or trigonometric interpolation.

In some embodiments, a sampling frequency of the upsampled digital loopback signal is at least two times the sampling frequency of the digital loopback signal.

**Communications Network**

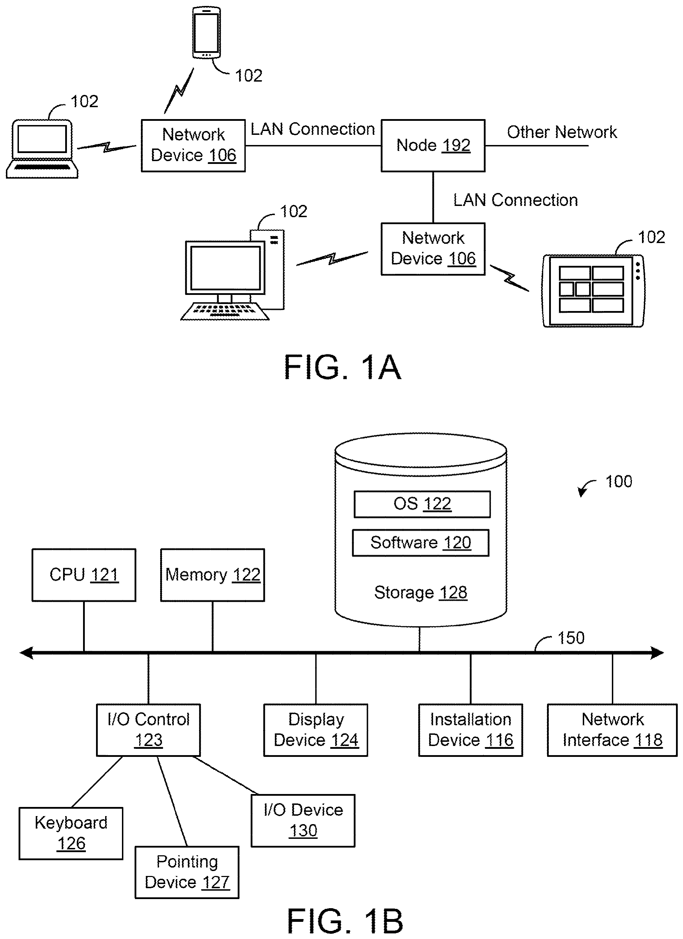

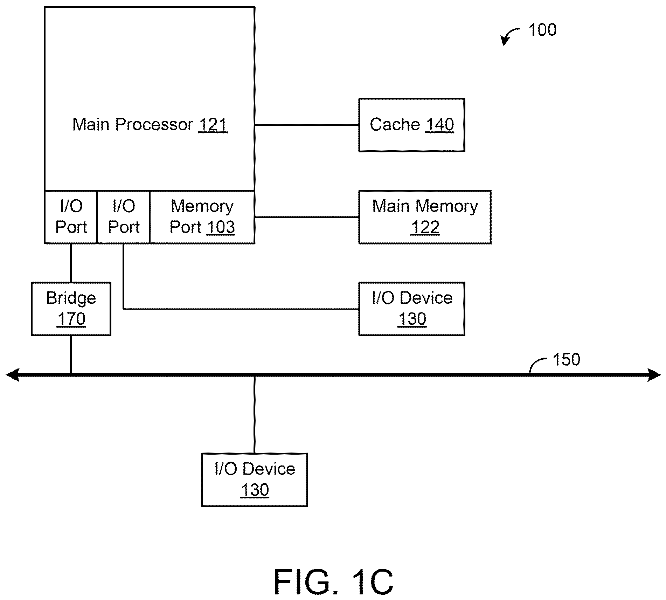

Prior to discussing certain embodiments, it can be helpful to describe aspects of the operating environment as well as associated system components (e.g., hardware elements) in connection with the methods and systems described herein. Referring to FIG. 1A, an embodiment of a network environment is depicted. In brief overview, the network environment includes a wireless communication system that includes one or more access points (APs) or network devices 106, one or more stations or wireless communication devices 102 and a network hardware component or network hardware 192. The wireless communication devices 102 can, for example, include laptop computers, tablets, personal computers, and/or cellular telephone devices. The details of an embodiment of each station or wireless communication device 102 and AP or network device 106 are described in greater detail with reference to FIGS. 1B and 1C. The network environment can be an ad hoc network environment, an infrastructure wireless network environment, a subnet environment, etc. in one embodiment. The network devices 106 or APs can be operably coupled to the network hardware 192 via local area network connections. Network devices 106 are 5G base stations in some embodiments. The network hardware 192, which can include a router, gateway, switch, bridge, modem, system controller, appliance, etc., can provide a local area network connection for the communication system. Each of the network devices 106 or APs can have an associated antenna or an antenna array to communicate with the wireless communication devices in its area. The wireless communication devices 102 can register with a particular network device 106 or AP to receive services from the communication system (e.g., via a SU-MIMO or MU-MIMO configuration). For direct connections (e.g., point-to-point communications), some wireless communication devices can communicate directly via an allocated channel and communications protocol. Some of the wireless communication devices 102 can be mobile or relatively static with respect to network device 106 or AP.

In some embodiments, a network device 106 or AP includes a device or module (including a combination of hardware and software) that allows wireless communication devices 102 to connect to a wired network using wireless-fidelity (WiFi), or other standards. A network device 106 or AP can sometimes be referred to as a wireless access point (WAP). A network device 106 or AP can be implemented (e.g., configured, designed and/or built) for operating in a wireless local area network (WLAN). A network device 106 or AP can connect to a router (e.g., via a wired network) as a standalone device in some embodiments. In other embodiments, network device 106 or AP can be a component of a router. Network device 106 or AP can provide multiple devices access to a network. Network device 106 or AP can, for example, connect to a wired Ethernet connection and provide wireless connections using radio frequency links for other devices 102 to utilize that wired connection. A network device 106 or AP can be implemented to support a standard for sending and receiving data using one or more radio frequencies. Those standards, and the frequencies they use can be defined by the IEEE (e.g., IEEE 802.11 standards). A network device 106 or AP can be configured and/or used to support public Internet hotspots, and/or on a network to extend the network's Wi-Fi signal range.

In some embodiments, the access points or network devices 106 can be used for (e.g., inhome, in-vehicle, or in-building) wireless networks (e.g., IEEE 802.11, Bluetooth, ZigBee, any other type of radio frequency based network protocol and/or variations thereof). Each of the wireless communication devices 102 can include a built-in radio and/or is coupled to a radio. Such wireless communication devices 102 and/or access points or network devices 106 can operate in accordance with the various aspects of the disclosure as presented herein to enhance performance, reduce costs and/or size, and/or enhance broadband applications. Each wireless communication device 102 can have the capacity to function as a client node seeking access to resources (e.g., data, and connection to networked nodes such as servers) via one or more access points or network devices 106.

The network connections can include any type and/or form of network and can include any of the following: a point-to-point network, a broadcast network, a telecommunications network, a data communication network, a computer network. The topology of the network can be a bus, star, or ring network topology. The network can be of any such network topology as known to those ordinarily skilled in the art capable of supporting the operations described herein. In some embodiments, different types of data can be transmitted via different protocols. In other embodiments, the same types of data can be transmitted via different protocols.

The communications device(s) 102 and access point(s) or network devices 106 can be deployed as and/or executed on any type and form of computing device, such as a computer, network device or appliance capable of communicating on any type and form of network and performing the operations described herein. FIGS. 1B and 1C depict block diagrams of a computing device 100 useful for practicing an embodiment of the wireless communication devices 102 or network device 106. As shown in FIGS. 1B and 1C, each computing device 100 includes a processor 121 (e.g., central processing unit), and a main memory unit 122. As shown in FIG. 1B, a computing device 100 can include a storage device 128, an installation device 116, a network interface 118, an I/O controller 123, display devices 124a-124n, a keyboard 126 and a pointing device 127, such as a mouse. The storage device 128 can include an operating system and/or software. As shown in FIG. 1C, each computing device 100 can also include additional optional elements, such as a memory port 103, a bridge 170, one or more input/output devices 130a-130n, and a cache memory 140 in communication with the central processing unit or processor 121.

The central processing unit or processor 121 is any logic circuitry that responds to and processes instructions fetched from the main memory unit 122. In many embodiments, the central processing unit or processor 121 is provided by a microprocessor unit, such as: those manufactured by Intel Corporation of Santa Clara, California; those manufactured by International Business Machines of White Plains, New York; or those manufactured by Advanced Micro Devices of Sunnyvale, California. The computing device 100 can be based on any of these processors, or any other processor capable of operating as described herein.

Main memory unit 122 can be one or more memory chips capable of storing data and allowing any storage location to be directly accessed by the microprocessor or processor 121, such as any type or variant of Static random access memory (SRAM), Dynamic random access memory (DRAM), Ferroelectric RAM (FRAM), NAND Flash, NOR Flash and Solid State Drives (SSD). The main memory unit 122 can be based on any of the above described memory chips, or any other available memory chips capable of operating as described herein. In the embodiment shown in FIG. 1B, the processor 121 communicates with main memory unit 122 via a system bus 150 (described in more detail below). FIG. 1C depicts an embodiment of a computing device 100 in which the processor communicates directly with main memory unit 122 via a memory port 103. For example, in FIG. 1C the main memory unit 122 can be DRDRAM.

FIG. 1C depicts an embodiment in which the main processor 121 communicates directly with cache memory 140 via a secondary bus, sometimes referred to as a backside bus. In other embodiments, the main processor 121 communicates with cache memory 140 using the system bus 150. Cache memory 140 typically has a faster response time than main memory unit 122 and is provided by, for example, SRAM, BSRAM, or EDRAM. In the embodiment shown in FIG. 1C, the processor 121 communicates with various I/O devices 130 via a local system bus 150. Various buses can be used to connect the central processing unit or processor 121 to any of the I/O devices 130, for example, a VESA VL bus, an ISA bus, an EISA bus, a MicroChannel Architecture (MCA) bus, a PCI bus, a PCI-X bus, a PCI-Express bus, or a NuBus. For embodiments in which the I/O device is a video display 124, the processor 121 can use an Advanced Graphics Port (AGP) to communicate with the display 124. FIG. 1C depicts an embodiment of a computer or computer system 100 in which the main processor 121 can communicate directly with I/O device 130b, for example via HYPERTRANSPORT, RAPIDIO, or INFINIBAND communications technology. FIG. 1C also depicts an embodiment in which local busses and direct communication are mixed: the processor 121 communicates with I/O device 130a using a local interconnect bus while communicating with I/O device 130b directly.

A wide variety of I/O devices 130a-130n can be present in the computing device 100. Input devices include keyboards, mice, trackpads, trackballs, microphones, dials, touch pads, touch screen, and drawing tablets. Output devices include video displays, speakers, inkjet printers, laser printers, projectors and dye-sublimation printers. The I/O devices can be controlled by an I/O controller 123 as shown in FIG. 1B. The I/O controller can control one or more I/O devices such as a keyboard 126 and a pointing device 127, e.g., a mouse or optical pen. Furthermore, an I/O device can also provide storage and/or an installation medium for the computing device 100. In still other embodiments, the computing device 100 can provide USB connections (not shown) to receive handheld USB storage devices such as the USB Flash Drive line of devices manufactured by Twintech Industry, Inc. of Los Alamitos, California.

Referring again to FIG. 1B, the computing device 100 can support any suitable installation device 116, such as a disk drive, a CD-ROM drive, a CD-R/RW drive, a DVD-ROM drive, a flash memory drive, tape drives of various formats, USB device, hard-drive, a network interface, or any other device suitable for installing software and programs. The computing device 100 can further include a storage device, such as one or more hard disk drives or redundant arrays of independent disks, for storing an operating system and other related software, and for storing application software programs such as any program or software 120 for implementing (e.g., configured and/or designed for) the systems and methods described herein. Optionally, any of the installation devices 116 could also be used as the storage device. Additionally, the operating system and the software can be run from a bootable medium.

Furthermore, the computing device 100 can include a network interface 118 to interface to a network through a variety of connections including, but not limited to, standard telephone lines, LAN or WAN links (e.g., 802.11, T1, T3, 56kb, X.25, SNA, DECNET), broadband connections (e.g., ISDN, Frame Relay, ATM, Gigabit Ethernet, Ethernet-over-SONET), wireless connections, or some combination of any or all of the above. Connections can be established using a variety of communication protocols (e.g., TCP/IP, IPX, SPX, NetBIOS, Ethernet, ARCNET, SONET, SDH, Fiber Distributed Data Interface (FDDI), RS232, IEEE 802.11, IEEE 802.11a, IEEE 802.11b, IEEE 802.11g, IEEE 802.11n, IEEE 802.11ac, IEEE 802.11ad, CDMA, GSM, WiMax and direct asynchronous connections). In one embodiment, the computing device 100 communicates with other computing devices 100' via any type and/or form of gateway or tunneling protocol such as Secure Socket Layer (SSL) or Transport Layer Security (TLS). The network interface 118 can include a built-in network adapter, network interface card, PCMCIA network card, card bus network adapter, wireless network adapter, USB network adapter, modem or any other device suitable for interfacing the computing device 100 to any type of network capable of communication and performing the operations described herein.

In some embodiments, the computing device 100 can include or be connected to one or more display devices 124a-124n. As such, any of the I/O devices 130a-130n and/or the I/O controller 123 can include any type and/or form of suitable hardware, software, or combination of hardware and software to support, enable or provide for the connection and use of the display device(s) 124a-124n by the computing device 100. For example, the computing device 100 can include any type and/or form of video adapter, video card, driver, and/or library to interface, communicate, connect or otherwise use the display device(s) 124a-124n. In one embodiment, a video adapter can include multiple connectors to interface to the display device(s) 124a-124n. In other embodiments, the computing device 100 can include multiple video adapters, with each video adapter connected to the display device(s) 124a-124n. In some embodiments, any portion of the operating system of the computing device 100 can be configured for using multiple display devices 124a-124n. In further embodiments, an I/O device 130 can be a bridge between the system bus 150 and an external communication bus, such as a USB bus, an Apple Desktop Bus, an RS-232 serial connection, a SCSI bus, a FireWire bus, a FireWire 800 bus, an Ethernet bus, an AppleTalk bus, a Gigabit Ethernet bus, an Asynchronous Transfer Mode bus, a FibreChannel bus, a fiber optic bus, a Serial Attached small computer system interface bus, a USB connection, or a HDMI bus.

A computing device 100 of the sort depicted in FIGS. 1B and 1C can operate under the control of an operating system, which controls scheduling of tasks and access to system resources. The computing device 100 can be running any operating system such as any of the versions of the MICROSOFT WINDOWS operating systems, the different releases of the Unix and Linux operating systems, any version of the MAC OS for Macintosh computers, any embedded operating system, any real-time operating system, any open source operating system, any proprietary operating system, any operating systems for mobile computing devices, or any other operating system capable of running on the computing device and performing the operations described herein. Typical operating systems include, but are not limited to: Android, produced by Google Inc.; WINDOWS 7, 8 and 10, produced by Microsoft Corporation of Redmond, Washington; MAC OS, produced by Apple Computer of Cupertino, California; WebOS, produced by Research In Motion (RIM); OS/2, produced by International Business Machines of Armonk, New York; and Linux, a freely-available operating system distributed by Caldera Corp. of Salt Lake City, Utah, or any type and/or form of a Unix operating system, among others.

The computer system or computing device 100 can be any workstation, telephone, desktop computer, laptop or notebook computer, server, handheld computer, mobile telephone or other portable telecommunications device, media playing device, a gaming system, mobile computing device, or any other type and/or form of computing, telecommunications or media device that is capable of communication. In some embodiments, the computing device 100 can have different processors, operating systems, and input devices consistent with the device. For example, in one embodiment, the computing device 100 is a smart phone, mobile device, tablet or personal digital assistant. Moreover, the computing device 100 can be any workstation, desktop computer, laptop or notebook computer, server, handheld computer, mobile telephone, any other computer, or other form of computing or telecommunications device that is capable of communication and that has sufficient processor power and memory capacity to perform the operations described herein.

### Digital Pre-Distortion with Band Limited Loopback

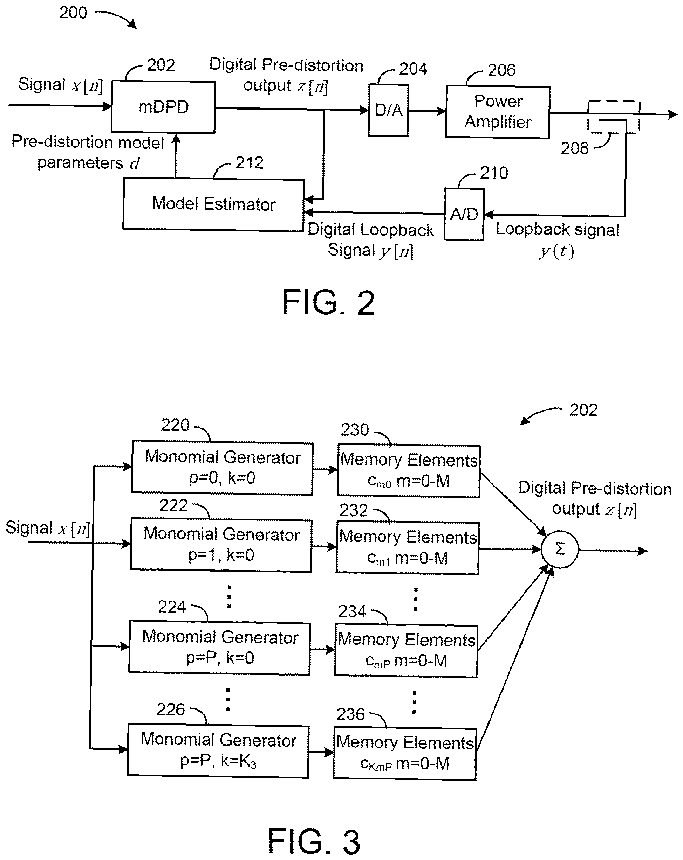

FIG. 2 is an illustrative block diagram of circuitry and its interconnection for a system (e.g., a device, apparatus, etc.) configured to perform digital pre-distortion of a signal prior to it being amplified. For example, the system may be part of a wireless communications network and the signal is being amplified prior to transmission. In order to ensure that the power content of the signal remains in the allocated channel for the transmission, digital pre-distortion may be applied prior to amplification to cancel (e.g., negate, invert, etc.) the nonlinear effect of the power amplifier. The circuitry, for example, may be implemented by any of the devices connected to or communicating with the networks shown in FIG. 1A. For example, the circuitry may be implemented within network device 106 and used communicate with any user device 102. In some embodiments, the circuitry may be implemented using one or more memory devices storing instructions to be executed by one or more processors. In some embodiments, the circuitry may be implemented using application specific integrated circuits (ASIC), digital signal processing (DSP) integrated circuits, or a system on a chip integrated circuit.

The processors may be a general purpose or specific purpose processors, an application specific integrated circuit (ASIC), one or more field programmable gate arrays (FPGAs), a DSP circuit, a group of processing components, or other suitable processing components. The processors may be configured to execute computer code and/or instructions stored in the memories or received from other computer readable media (e.g., CDROM, network storage, a remote server, etc.). The processors may be configured in various computer architectures, such as graphics processing units (GPUs), distributed computing architectures, cloud server architectures, client-server architectures, or various combinations thereof. One or more first processors can be implemented by a first device, such as an edge device, and one or more second processors can be implemented by a second device, such as a server or other device that is communicatively coupled with the first device and may have greater processor and/or memory resources.

The memories may include one or more devices (e.g., memory units, memory devices, storage devices, etc.) for storing data and/or computer code for completing and/or facilitating the various processes described in the present disclosure. The memories may include random access memory (RAM), read-only memory (ROM), hard drive storage, temporary storage, non-volatile memory, flash memory, optical memory, or any other suitable memory for storing software objects and/or computer instructions. The memories may include database components, object code components, script components, or any other type of information structure for supporting the various activities and information structures described in the present disclosure. The memories may be communicably connected to the processors and can include computer code for executing (e.g., by the processors) one or more processes described herein.

Amplifying device 200 is shown to include several interconnected circuits according to some embodiments. The amplifying device 200 may include memory a digital pre-distortion (mDPD) circuit 202, a digital-to-analog converter 204, a power amplifier 206, a coupler 208, an analog-to-digital converter 210, and a model estimator circuit 212. It should be understood that in some embodiments the functionality of the amplifying device 200 may be distributed differently across any number of circuits. For example, the mDPD circuit 202 and the model estimator circuit 212 may be performed in a single circuit.

In some embodiments, amplifying device 200 also includes a coordinator circuit configured to control the timing and flow of data through the other circuitry of amplifying device 200. For example, the coordinator circuit may cause the modules or circuits to execute in a specific order to perform the function of amplifying device 200. In some embodiments, the coordinating circuit may route the information and/or outputs of other circuits or modules that are dependent on the information or use the information as an input.

Instructions, modules, portions of memory, etc. described as configured to perform a function (or described as performing the function) may include embodiments for which the module is configured to cause the performance of the function (or is causing the performance of the function). Similarly, instructions, modules, portions of memory, etc. described as configured to cause the performance of a function (or described as causing the performance of a function) may include embodiments for which the module is configured to perform the function (or is performing the function).

The mDPD circuit 202 may be configured to perform digital pre-distortion of the of an input signal to be amplified (e.g., signal $x[n]$). Digital pre-distortion may be used to enhance the linearity of power amplifiers in communication systems. For example, the mDPD circuit 202 may receive a model (e.g., model parameters, a function, etc.) from the model estimator circuit 212 and apply it to the signal to be amplified. With proper estimation, the model may counteract (e.g., inverse, negate, etc.) the nonlinear effects of the amplifier.

In some embodiments, the mDPD circuit 202 is configured to use a Volterra series to perform the digital pre-distortion. The Volterra series may be given by:

$$z[n] = \sum_{m=0}^{M_1} \sum_{p=0}^{P_1[m]} c_{m,p}^{(1)} x[n-m]|x[n-m]|^p \ldots$$

$$+ \sum_{k=1}^{K_2} \sum_{m=0}^{M_2[k]} \sum_{p=0}^{P_2[k,m]} c_{k,m,p}^{(2)} x[n-m]|x[n-m-k]|^p \ldots \qquad equation\ 3$$

$$+ \sum_{k=1}^{K_3} \sum_{m=0}^{M_3[k]} \sum_{p=0}^{P_3[k,m]} c_{k,m,p}^{(3)} x[n-m-k]|x[n-m]|^p.$$

where $n$ is the time index, $x$ is the input signal, and $z$ is the output signal and index $p$ is related to the power of the expansion term, index $m$ is a number of samples into the past, and index $k$ is a number of samples between the two terms of the expansion. The first group of terms in the Volterra series may represent the varying powers of the input signal (e.g., starting with the input itself when $p = 0$). For example, with $P_1 = = P_2 = P_3 = 0$ and $K_2 = K_3 = 0$ the Volterra series may reduce to a linear time-invariant difference equation of order $M_1$. As the $P$ or $K$ values are increased nonlinear terms may be introduced. For example, with $P_1 = 1$, $P_2 = P_3 = 0$ and $K_2 = K_3 = 0$ the series may provide a difference equation of the input $x$ and of $x^2$.

FIG. 3 shows a block diagram of the mDPD model within the mDPD circuit, according to some embodiments. The monomial generators 220-226 may be configured to perform a nonlinear operation on the input signal and/or different lag terms of the input signal. The output of a monomial generator (e.g., from monomial generators 220-226) may be a single monomial term (e.g., $x |x|^2$, for $p = 2$). In some embodiments, memory coefficients are applied to the output of each monomial generator. A memory element (e.g. from memory elements 230-236) may be configured to store a number of (e.g., $M$) previous outputs of a respective monomial generator (e.g., from a monomial generator 220-226) and form a linear combination of those outputs. For example, the memory elements 232 may receive $x |x|$ from the monomial generator 222 and generate an output given by:

$$\sum_{m=0}^{M_1} c_{m,1}^{(1)} x[n-m]|x[n-m]|. \qquad equation\ 4$$

In some embodiments, the summation of all the memory elements 230-236 is the digital pre-distortion output $z[n]$.

Referring again to FIG. 2, amplifying device 200 may include a digital-to-analog converter (D/A) 204 configured to convert the digital pre-distorted signal $z[n]$ to an analog signal for amplification by the power amplifier 206. The digital-to-analog converter 204 may be any type of digital-to-analog converter. For example, the digital-to-analog converter 204 may be a sigma-delta digital-to-analog converter configured to perform pulse-density modulation or the digital-to-analog converter 204 may be a pulse-width modulated digital-to-analog converter.

In some embodiments, power amplifier 206 is configured to amplify the signal leaving the digital-to-analog converter 204. The power amplifier may increase the signal to a level that it can be transmitted (e.g., over the air via an antenna) to a receiving device. It is noted that the power amplifier 206 may be introduce nonlinearities and may cause the frequency spectrum of the signal to expand into different frequency ranges than those included in the input signal necessitating the mDPD circuit 202.

In some embodiments, a modulation circuit may be included as part of the digital-to-analog converter 204 block, the power amplifier 206, or as its own circuit between the two circuits. The modulation circuit may be configured to translate the frequency band of the signal from baseband to carrier frequency. For example, the modulation circuit may take a 320 MHz bandwidth baseband signal (e.g., on the frequency range from -160 to 160 MHz) and modulate the signal with a 5 GHz carrier frequency to create a signal between 4.84 GHz and 5.16 GHz.

The coupler 208 may be configured to obtain (e.g., acquire, receive) a representation (e.g., portion, measurement, sampling, etc.) of the output signal from the power amplifier without significantly affecting the main output (e.g., without significant attenuation or distortion). The loopback signal y(t) obtained by the coupler 208 may be directed towards an analog-to-digital converter 210 for processing.

The analog-to-digital converter 210 may be configured to sample the loopback signal $y(t)$ at a sampling frequency (e.g., 256 MHz, 512 MHz, etc.) to create a digital loopback signal y[n] Sampling the loopback signal may include creating and/or storing a record for the digital loopback signal so that it can be used by the model estimator circuit 212 to determine an model for the mDPD circuit 202. In some embodiments, a demodulator circuit is disposed between the coupler 208 and the analog-to-digital converter 210 to translate the frequency content down from a carrier frequency to a baseband frequency. In some embodiments, an antialiasing filter is disposed between the coupler 208 and the analog-to-digital converter 210 to eliminate frequency content greater than the Nyquist frequency at the sampling rate of the analog-to-digital converter 210. For example, if the analog-to-digital converter 210 samples the loopback signal at a frequency of 512 MHz, an antialiasing filter that reduces or eliminates frequencies above 256 MHz may be used.

In some embodiments, the model estimator circuit 212 may be configured to determine a digital pre-distortion model (e.g., a Volterra series, lookup table, etc.) that can be applied to negate (e.g., invert, compensate for, etc.) the nonlinear effects of the power amplifier 206. The model estimator circuit 212 may communicate pre-distortion model parameters, the model, etc. to the mDPD circuit. The model estimator circuit 212 may perform indirect learning. For example, the model estimator circuit 212 may use digital input to the power amplifier and the digital loopback signal to estimate a model that is the inverse of the power amplifier 206 as depicted in FIG 2. In some embodiments, the model estimator circuit may perform direct learning. For example, the model estimator circuit 212 may use the signal to be amplified and the digital loop back signal to estimate a model of the power amplifier's 206 effect. The model estimator circuit 212 may then determine the inverse of the estimated model for the mDPD circuit.

The model estimator circuit 212 may perform least squares estimation of the pre-distortion model. For example, in the case of indirect model estimation where the model is a Volterra series the model estimator circuit may formulate a least squares linear regression problem to determine the Volterra coefficients that best estimate the digital pre-distortion output $z[n]$ using the digital loopback signal $y[n]$. The least squares problem can be formulated in matrix form as:

$$
\begin{bmatrix} z[0] \\ z[1] \\ \vdots \\ z[N] \end{bmatrix} =
$$

$$
\begin{bmatrix} y[0] & y[0]|y[0]| & \cdots & y[0]|y[0]|^{P1} & \cdots & y[0]|y[-1]|^{P1} & \cdots & y[-1] & \cdots \\ y[1] & y[1]|y[1]| & \cdots & y[1]|y[1]|^{P1} & \cdots & y[1]|y[0]|^{P1} & \cdots & y[0] & \cdots \\ \vdots & \vdots & \cdots & \vdots & \cdots & \vdots & \cdots & \vdots & \cdots \\ y[N] & y[N]|y[N]| & \cdots & y[N]|y[N]|^{P1} & \cdots & y[N]|y[N-1]|^{P1} & \cdots & y[N-1] & \cdots \end{bmatrix} \begin{bmatrix} c_{0,0} \\ c_{0,1} \\ \vdots \\ c_{0,P1} \\ \vdots \\ c_{1,0,P1} \\ \vdots \\ c_{1,0} \\ \vdots \end{bmatrix},
$$

*equation 5*

or

$$
z = Yc. \quad equation\ 6
$$

The solution to the least squares problem (e.g., the values of the coefficients c that minimize the error in the estimates of *z*) can be found using the pseudoinverse:

$$
c = (Y^H Y)^{-1} Y^H z. \quad equation\ 7
$$

where H represents the Hermitian transpose (e.g., the conjugate transpose).

In some embodiments, the model estimator circuit 212 periodically updates the coefficients by collecting data to form the matrix *Y* and the vector *z* and performing the pseudoinverse. In some embodiments, the coefficients are updated for each sample of the signal performing least mean squares (LMS). For example, the coefficients may be updated by:

$$
c[n + 1] = c[n] + \mu y[n](z[n] - y[n]c[n]), \quad equation\ 8
$$

where $\mu$ is a small step size and $y[n]$ denotes a row of the matrix *Y*. In some embodiments, the coefficients are updated for each sample using recursive least squares (RLS). For example, the model estimator circuit 212 may maintain (e.g., store, save, etc.) an estimate of the inverse of the weighted (e.g., by a forgetting factor) sample covariance matrix (e.g., related to $(Y^T Y)^{-1}$) and recursively update the weighted sample covariance matrix using the current values of $y$ and $z$ and update the coefficients based on the weighted sample covariance matrix and the current values.

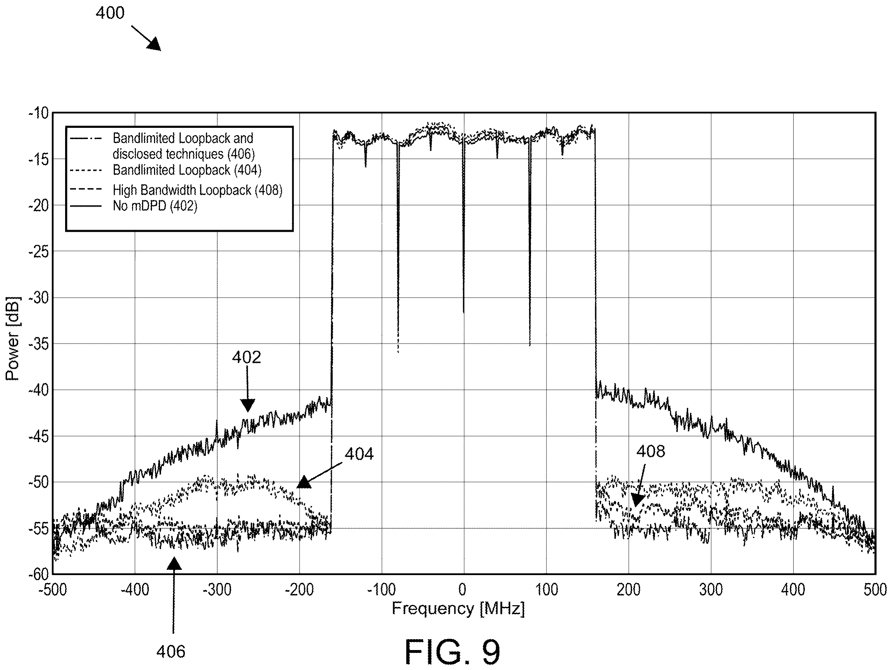

Referring ahead briefly to FIG. 9, plot 400 shows the power as a function of frequency for an amplifying device 200. The signal bandwidth is 320 MHz (e.g., -160 MHz to 160 MHz). Trace 402 shows the frequency spectrum output from the power amplifier with no digital pre-distortion. A significant amount of spectral regrowth is visible outside of the frequency band. Memory digital pre-distortion (mDPD) may be performed; however, sampling at the rate required for full mDPD performance (e.g., fast enough to support the maximum frequency caused by the nonlinearities in the amplification circuits) may require expensive circuitry. Amplifiers may have an analog-to-digital converter that samples at a lower frequency and the antialiasing filter may limit the bandwidth of the loopback signal leading to non-ideal performance shown in trace 404. In some embodiments, operating a filter on the output of the mDPD may increase performance as shown in traces 406.

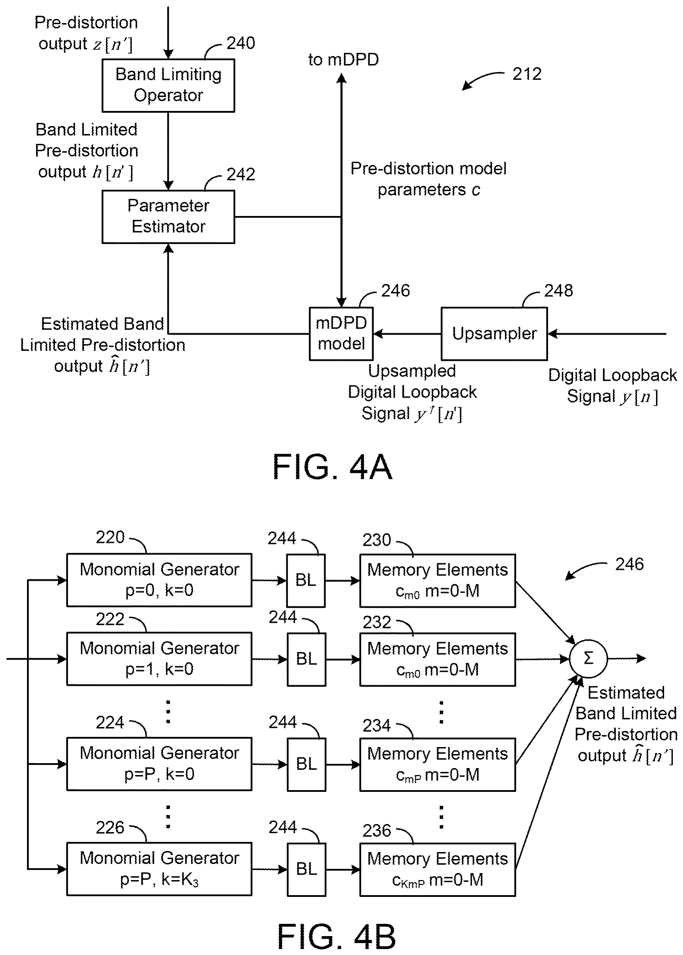

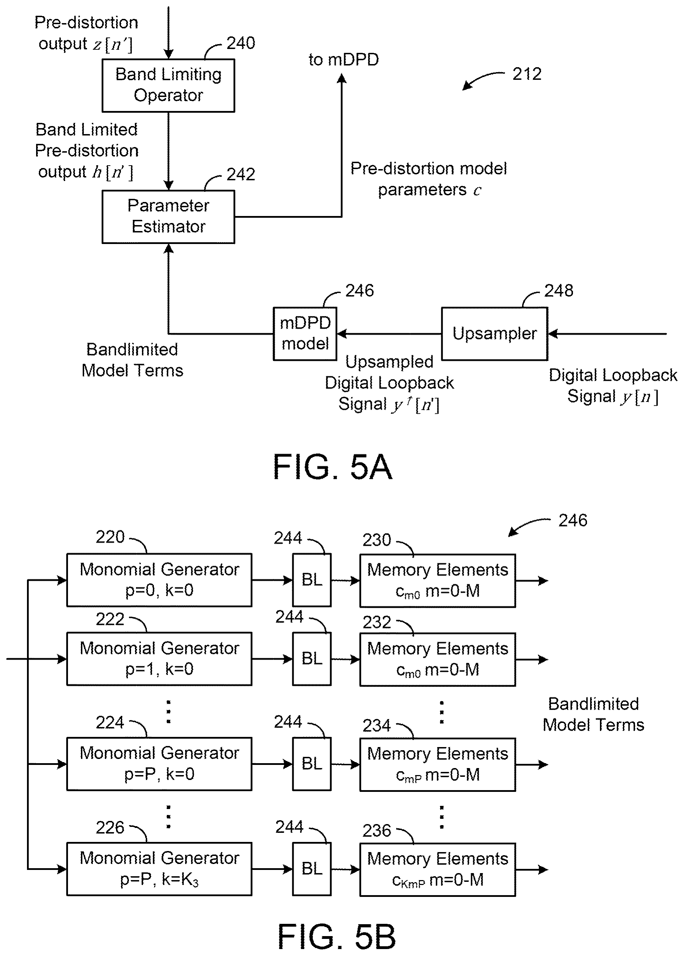

FIGS. 4 and 5 show detailed block diagrams of the model estimator circuit 212 according to some embodiments. The model estimator circuit 212 may include an input band limiting operator 240, a parameter estimator 242, an output band limiting operator 244, an mDPD model circuit 246, and upsampler 248. In some embodiments, digital loop back signal $y[n]$ and pre-distortion output $z[n]$ are inputs to the model estimator circuit 212, and the parameter estimates of the mDPD model circuit 246 are output to the mDPD circuit 202. The configuration of the model estimator circuit 212 may depend on the form of model estimation used. For example, FIGS. 4A and 4B show the model estimator circuit 212 configured to use an iterative (e.g., recursive, incremental, adaptive, etc.) least squares approach to identify (e.g., determine, find, etc.) the parameters for the mDPD circuit 202, according to some embodiments. FIGS. 5A and 5B show the model estimator circuit 212 configured to use least squares approach based on the pseudo-inverse, according to some embodiments.

In some embodiments, the upsampler 248 is configured to upsample the digital loopback signal by adding samples between the samples obtained by the analog-to-digital converter 210. Upsampling may be performed by storing new samples in between the records of existing samples, for example, if estimation is performed in a batch method (e.g., the pseudo-inverse described herein). Upsampling may also be performed by adding records within a stream of data. The upsampler 248 may include additional memory units that obtain a sample based on time adjacent memory units with data obtained from the digital loop back signal. For example, as data is streamed in, each time the upsampler 248 receives a new sample of the digital loop back signal it may create two samples of the upsampled digital loopback signal. At upsampled time index n' the most recent value of $y^\uparrow$ may be moved back two positions in a set of memory elements (e.g., to $y^\uparrow[n' - 2]$) and the new value may be stored at $y^\uparrow[n']$. $y^\uparrow[n' - 1]$ may be found using linear interpolation between $y^\uparrow[n' - 2]$ and $y^\uparrow[n']$.

The upsampler 248 may use various methods of interpolation. For example, the upsampler 248 may use linear interpolation, polynomial interpolation, spline interpolation, and/or trigonometric interpolation. Any number of data points may be used to perform the interpolation. For example, polynomial interpolation may be repeated using the most recent five samples of the digital loopback signal to fit a quartic (e.g., polynomial of power four). After a new sample is obtained, the upsampled digital loopback signal for $y^\uparrow[n']$ to $y^\uparrow[n' - 9]$ may be of the form [M, X, M, X, M, I, M, I, M, I], indicating that every other sample, $y^\uparrow[n']$, $y^\uparrow[n' - 2]$, $y^\uparrow[n' - 4]$, ... has a measured (e.g., sampled) value from the digital loopback signal (indicated by M), $y^\uparrow[n' - 1]$ and $y^\uparrow[n' - 3]$ have not yet been found by interpolation (indicated by X), and $y^\uparrow[n' - 5]$, $y^\uparrow[n' - 7]$ and $y^\uparrow[n' - 9]$ have been previously found via interpolation (indicated by I). With the new value, it may be possible to find $y^\uparrow[n' - 3]$ by quartic interpolation using the points $y^\uparrow[n']$, $y^\uparrow[n' - 2]$, $y^\uparrow[n' - 4]$, $y^\uparrow[n' - 6]$ and $y^\uparrow[n' - 8]$, (e.g., two points after and three points before the sample to be interpolated). This process may be repeated each time a new point is received. Advantageously, the least squares fit does not have to be performed on each step. Instead, the fit can be performed once, and the parameters can be saved so that during calculation the unknown value can be calculated as a linear combination of the values used to perform the interpolation. In some embodiments, the upsampler may perform extrapolation instead of interpolation (e.g., so that all samples up to the current time are known).

Upsampling the digital loopback signal may allow for all frequency components that occur from the nonlinear operations of the mDPD model circuit 246 to be properly represented in the digital domain. Upsampling may have the effect of eliminating one source of mismatch between the mDPD model circuit and the nonlinear effects of the power amplifier and thus improve performance of the pre-distortion technique. In some embodiments, the sampling frequency of the upsampler 248 is chosen to accommodate the harmonics (e.g., sample fast enough to support the harmonic) created by the maximal polynomial degree of the mPDP 202.

In some embodiments, the mDPD model circuit 246 is configured to estimate the pre-distortion output from the upsampled digital loopback signal. By adjusting the parameters of the mDPD model circuit 246 so that the output matches the digital pre-distortion output, parameters for the mDPD circuit 202 can be found. In some embodiments, the mDPD model circuit 246 is configured to output bandlimited model terms for use by the parameter estimator 242.

In some embodiments, the band limiting operator 244 is configured to eliminate certain frequencies from the estimated pre-distortion output. For example, the band limiting operator 244 may be configured as a low pass filter. The band limiting operator 240 may perform the same operation as the band limiting operator 244. In some embodiments, the digital loopback signal is bandlimited (e.g., by an antialiasing filter for a lower sampling frequency), the band limiting operators 240 and 244 may cause the parameter estimator 242 to perform estimation based on the frequency bands for which feedback is provided via the digital loopback signal. Without the band limiting operators 240 and 244 the mDPD model circuit 246 may also learn to inverse (e.g., negate, compensate for, etc.) the antialiasing filter, which when applied by the mDPD circuit 202 would degrade the performance of the pre-distortion technique. The band limiting operators 240 and 244 may be chosen based on the band limiting inherent in the digital loopback signal (e.g., the antialiasing filter and/or the sampling frequency). For example, the band limiting operators 240 and 244 may be chosen based on the cutoff frequency of the antialiasing filter (e.g., chosen to be more restrictive). The band limiting operators 240 may be implemented as an infinite impulse response (IIR) filter or a finite impulse response (FIR) filter.

The parameter estimator 242 may be configured to adjust the parameters of the mDPD model circuit 246 to parameters that cause the two inputs to the parameter estimator 242 to match. For example, the parameter estimator 242 may be configured to determine model parameters that cause the band limited pre-distortion output $h[n']$ to match the estimated band limited pre-distortion output $\hat{h}[n']$ (e.g., coming from the mDPD model circuit 246). The parameters estimated (e.g., identified, etc.) by the parameter estimate for the mDPD model circuit 246 may be communicated by the parameter estimator to the mDPD circuit 202. For example, the parameters estimated may be stored in a shared memory location accessible by both circuits. In some embodiments, the parameter estimator 242 is configured to perform a least squares estimation based on the pseudo-inverse to determine coefficients of the Volterra series expansion.

FIG. 4A shows a block diagram of the model estimator circuit 212 configured to use an iterative (e.g., recursive, incremental, adaptive, etc.) least squares approach to identify (e.g., determine, find, etc.) the parameters for the mDPD circuit 202, according to some embodiments. The digital loopback signal may be upsampled by the upsampler 248 to allow for all frequency components that occur from the nonlinear operations of the mDPD model circuit 246 to be properly represented in the digital domain. The mDPD model circuit 246 may output the sum of the individual monomial terms as shown in FIG. 4B. The output of the monomial generators 220-226 may be filtered by the band limiting operator 244. The memory elements 230-236 can apply a weight to the previous outputs of the band limiting operators 244 before being summed and output from the mDPD model circuit 246. In some embodiments, the band limiting operator 244 may be disposed differently, for example, after the memory elements 230-236 or at the output of the mDPD model circuit 246. The band limiting operator 244, may ensure that information regarding the inherent band limiting in the digital loopback signal (e.g., the antialiasing filter and/or the sampling frequency) is not received by the parameter estimator 242. Without the band limiting operator 244 the parameter estimator 242 may also invert the inherent band limiting reducing performance of the digital pre-distortion technique. The band limiting operator 240 may similarly apply a low pass filter (e.g., the same operation as band limiting operator 244) so that the band limited pre-distortion output $h[n']$ and the estimated band limited pre-distortion output $\hat{h}[n']$ can be compared by the parameter estimator 242.

FIG. 4A shows the sampling frequency of the transmitter side (e.g., the sampling frequency of the pre-distortion output z) equal to the upsampled frequency (e.g., all signals use the sampling index $n'$). It is contemplated that the transmitter side can be sampled at a frequency different than the upsampled frequency and/or different than the sampling frequency of the digital loopback signal. For example, the sampling frequency of the transmitter side may be chosen based on the Nyquist frequency of the signal to be amplified x. In some embodiments, a down-sampler (e.g., decimator) is disposed between the parameter estimation 242 and the band limiting operator 244 to cause the sampling frequency for the two signals compared by the parameter estimator 242 to match.

The parameter estimator 242 may be configured to adjust the parameters of the mDPD model circuit 246 to parameters that cause the two inputs to the parameter estimator 242 to match. For example, the parameter estimator 242 may be configured to determine model parameters that cause the band limited pre-distortion output $h[n']$ to match the estimated band limited pre-distortion output $\hat{h}[n']$ (e.g., coming from the mDPD model circuit 246). Iterative (e.g., recursive, adaptive, etc.) approaches may be used to adjust the parameters of the mDPD model circuit 246 and the mDPD circuit 202. For example, least squares approaches including LMS and RLS may be used. The parameters estimated (e.g., identified, etc.) by the parameter estimate for the mDPD model circuit 246 may be communicated by the parameter estimator to the mDPD circuit 202. For example, the parameters estimated may be stored in a shared memory location accessible by both circuits (e.g., the mDPD model circuit 246 and the mDPD circuit 202).

FIG. 5A shows a block diagram of the model estimator circuit 212 configured to use least squares approach based on the pseudo-inverse to find the parameters for the mDPD circuit 202, according to some embodiments. The digital loopback signal may be upsampled by the upsampler 248 to allow for all frequency components that occur from the nonlinear operations of the mDPD model circuit 246 to be properly represented in the digital domain. The mDPD model circuit 246 may output the individual monomial terms as shown in FIG. 5B. The band limiting operator 244 may be applied to each of the monomial terms of the Volterra series individually prior to being output from the mDPD model circuit 246. Similar to the embodiments shown in FIG. 4A the band limiting operator may be chosen based on the band limiting inherent in the digital loopback signal (e.g., the antialiasing filter and/or the sampling frequency). For example, the band limiting operator 244 may be chosen based on the cutoff frequency of the antialiasing filter (e.g., chosen to be more restrictive). Each of the terms of the mDPD model circuit 246 may be output and received by the parameter estimator 242 to be included in the matrix used to perform least squares estimation. The band limiting operator 240 may similarly apply a low pass filter (e.g., the same operation as band limiting operator 244) so that the band limited pre-distortion output $h[n']$ and band limited model terms can be compared by the parameter estimator 242 to find the pre-distortion model parameters by solving the equation $h = Y'c$ by pseudo-inverse $c = (Y'^H Y')^{-1} Y'^H h$ where $Y'$ is the matrix $Y$ from equation 5 using the band limited model terms and $h$ is a vector of the band limited pre-distortion output signal $h[n']$. The pre-distortion model parameters can be communicated (e.g., sent, etc.) to the mDPD circuit 202.

In some embodiments, mDPD model circuit 246, the band limiting operator 240, and the parameter estimator 242 are embodied by a least squares estimation problem represented in matrix form. The band limiting operators 240 and 244 are represented by a matrix that is multiplied by the matrix $Y$ (e.g., representing the band limiting operator 244 multiplying each monomial term as in FIG. 5B) and the vector $z$ (e.g., representing the band limiting operator 240). For example, a FIR filter that has the equation $h[n] = 0.4y[n] + 0.3y[n - 1] + 0.2y[n - 2] + 0.1y[n - 3]$ may be represented by the matrix:

$$w = \begin{bmatrix} 0.4 & 0.3 & 0.2 & 0.1 & 0 & 0 & ... & 0 \\ 0 & 0.4 & 0.3 & 0.2 & 0.1 & 0 & ... & \vdots \\ \vdots & 0 & 0.4 & 0.3 & 0.2 & 0.1 & & \vdots \\ & \vdots & 0 & 0.4 & 0.3 & 0.2 & \ddots & 0 \\ & & \vdots & 0 & 0.4 & 0.3 & \ddots & 0.1 \\ & & & \vdots & 0 & 0.4 & \ddots & 0.2 \\ \vdots & \vdots & \vdots & \vdots & \vdots & 0 & ... & 0.3 \\ 0 & 0 & 0 & 0 & 0 & 0 & & 0.4 \end{bmatrix} . \; equation \; 9$$

where w is the same size as the vector $z$ (e.g., has size equal to the number of samples used to perform the estimation). Estimates for the coefficients of the Volterra series of the mDPD model circuit 246 may be found by:

$$c = ((wY)^H wY)^{-1} (wY)^H wz. \; equation \; 10$$

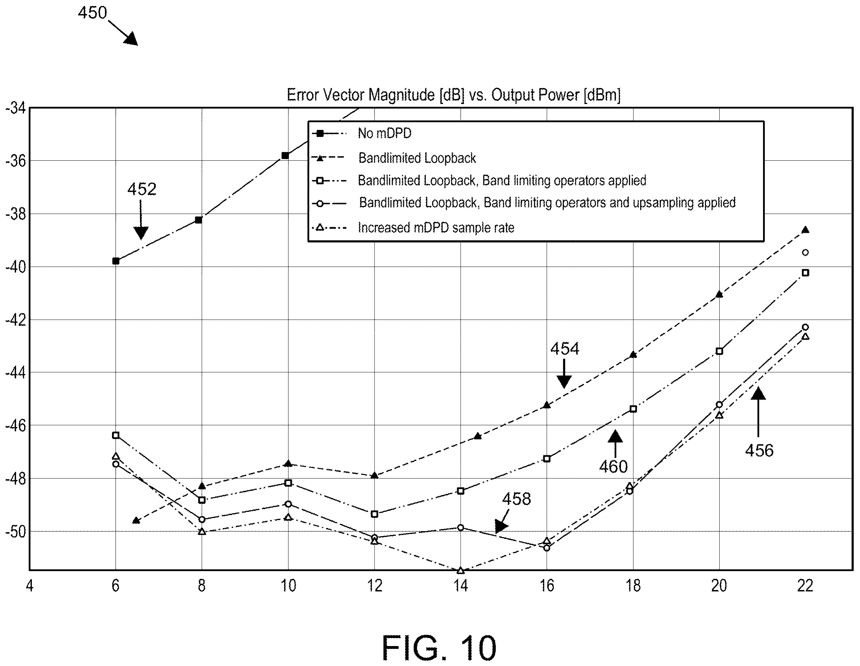

FIGS. 9 and 10 show that digital pre-distortion as described herein (e.g., using band limiting operators on both the mDPD model output and the mDPD output and upsampling the digital loop back signal) provides performance comparable to a high bandwidth loopback signal when the loopback signal is band limited. Advantageously, the described digital pre-distortion allows for the use of less expensive analog-to-digital converters that sample at a lower frequency (e.g., at a sampling frequency equal to the bandwidth of the signal being amplified) rather than a sampling rate that can support the maximum frequency caused by the nonlinearities in the amplifier as necessary for full performance in traditional digital pre-distortion.

FIG. 9 shows the out-of-band power for a signal with bandwidth of 320 MHz. Trace 402 shows the out-of-band power (e.g., less than -160 MHz or greater than 160 MHz) for a signal amplified with no digital pre-distortion. Trace 404 shows the output of band power for a signal amplified after digital pre-distortion for which the loopback is bandlimited with a 3dB frequency at 220 MHz. Trace 406 shows the out-of-band power for a signal amplified after digital pre-distortion for which the loopback is band limited with a 3dB frequency at 220 MHz, and upsampling and the band limiting operators are used (e.g., band limiting operators 240 and 244). Trace 408 shows a traditional digital pre-distortion method when the bandwidth of the loopback is 1000 MHz (e.g., > 3 times the bandwidth of the signal). The presently disclosed methods (trace 406) show similar performance to digital pre-distortion with a high bandwidth loopback (trace 408), whereas traditional techniques suffer from elevated spectral regrowth when the loopback is bandlimited (trace 404).

FIG. 10 shows the error vector magnitude (EVM) (e.g., the distance of a received signal on a constellation diagram from the ideal location for the sent symbol) as a function of power according to some embodiments on plot 450. As output power grows the nonlinearity of the power amplifier 206 increases (e.g., due to increasing nonlinear effects of amplifier saturation) and the error vector magnitude increases. The bandwidth of the signal amplified was 320 MHz. Trace 452 is the EVM as a function of power for a transmission system with amplifier that uses no digital pre-distortion. Trace 454 is the EVM as a function of power for a transmission system with amplifier that uses a traditional digital pre-distortion system receiving the loopback signal with a sampling frequency of 512 MHz (e.g., 1.6 times the bandwidth of the signal). Trace 456 is the EVM as a function of power for a transmission system with amplifier that uses the upsampling and band limiting operations of the currently disclosed digital pre-distortion system, the loopback signal was received with a sampling frequency of 512 MHz and upsampled to 1024 MHz for model estimation. Trace 456 shows roughly a 3 dB increase in output power for a similar EVM. Trace 458 shows the EVM as a function of power when band limiting and upsampling is performed, additionally the digital pre-distortion was applied at a higher frequency. Trace 460 shows the results when the band limiting operation is applied, but without upsampling. Plot 450 shows that there are advantages in performing either the band limiting operations or the upsampling, but better performance is obtained when performing both.

Referring back to FIGS. 4 and 5, in some embodiments, upsampling is not performed (e.g., the upsampler 248 is not included in the model estimator circuit 212) and the band limiting operators 240 and 244 are included. In some embodiments, upsampler 248 is included, but band limiting is not performed (e.g., the band limiting operators 240 and 244 are not included). In some embodiments, both upsampling and band limiting is performed. Other combinations of the circuits or elements in the amplifying device 200 should be considered within the scope of the current application.

## Operational Flow

The circuitry of the amplifying device 200 may execute methods (e.g., processes, operations, etc.) for performing digital pre-distortion of signal to be amplified. These methods may allow a device to achieve high digital pre-distortion performance even when the loopback signal is bandlimited (e.g., by a low sampling rate). For example, with a loopback that is limited to less than the sampling frequency required to represent the maximal frequency caused by the nonlinear components or is otherwise bandlimited by the loopback channel.

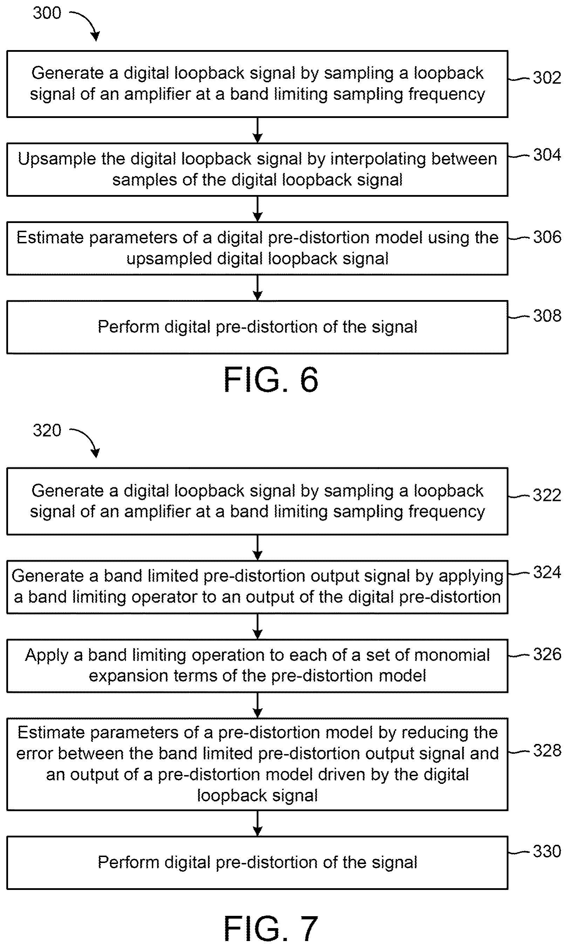

With reference to FIG. 6, flow of operations 300 shows operations for performing digital pre-distortion of a signal using a bandlimited loopback, according to some embodiments. The operations of the flow of operations 300 may be performed by any of the circuits of the amplifying device 200.

In some embodiments, flow of operations 300 includes generating a digital loopback signal by sampling a loopback signal of an amplifier at a band limiting sampling frequency in operation 304. A band limiting sampling frequency may refer to any frequency that does not support full bandwidth expansion caused by the nonlinearities of the power amplifier 206. The maximal frequency of the bandwidth expansion may depend on the power amplifier 206. For some amplifiers, a loopback sampling frequency less than 2 times the bandwidth of the signal input may be considered band limiting. The coupler 208 may direct a representation of the amplified signal back to the analog-to-digital converter 210. The analog-to-digital converter 210 may be configured to sample the loopback signal at a sampling frequency (e.g., 256 MHz, 512 MHz, etc.) to create a digital loopback signal by storing (e.g., saving) the samples in memory. In some embodiments, a demodulator circuit is disposed between the coupler 208 and the analog-to-digital converter 210 to translate the frequency content down from a carrier frequency to a baseband frequency. In some embodiments, an antialiasing filter is disposed between the coupler 208 and the analog-to-digital converter 210 to eliminate frequency content greater than the Nyquist frequency at the sampling rate of the analog-to-digital converter 210. The power amplifier 206 may introduce nonlinearities that cause frequency content to be generated outside of the bandwidth of the input signal (e.g., spectral regrowth). The methods described herein allow high digital pre-distortion performance without sampling at a high enough frequency that would allow all the frequency content of the power amplifier 206 output to be represented in the digital domain. For example, the digital loopback signal may be sampled at a frequency equal to the bandwidth of the original signal to be amplified or the digital loopback signal may be sampled at a frequency equal to twice the bandwidth of the original signal to be amplified.

In some embodiments, flow of operations 300 includes upsampling the digital loopback signal by interpolating between samples of the digital loopback signal in operation 304. The upsampler 248 may upsample the digital loopback signal by adding samples between the samples obtained by the analog-to-digital converter 210. Upsampling may be performed by storing new samples in between the records of existing samples, for example, if estimation is performed in a batch method (e.g., the pseudo-inverse described herein). Upsampling may also be performed by adding records within a stream of data (e.g., stored in RAM, registers, etc.). Various methods of interpolation may be used to perform upsampling. For example, linear interpolation, polynomial interpolation, spline interpolation, and/or trigonometric interpolation may be used. Any number of data points may be used to perform the interpolation and any number of samples may be on either side of the sample that is being generated (e.g., created, added, etc.). In some embodiments, the upsampler may perform extrapolation instead of interpolation (e.g., so that all samples of the upsampled signal up to the current time are known). Upsampling the digital loopback signal may allow for all frequency components that occur from the nonlinear operations of the mDPD model circuit 246 to be properly represented in the digital domain and may eliminate a potential aliasing effect.

In some embodiments, flow of operations 300 includes estimating parameters of a digital pre-distortion model using the upsampled digital loopback signal. For example, the model estimator circuit 212 may generate a model (or parameters for a model) that estimates the output of the mDPD circuit 202 from the output of the power amplifier 206. The model generated may invert (e.g., negate, cancel, etc.) the nonlinear effect of the power amplifier 206. In some embodiments, the model is Volterra model that is estimated by generating a matrix of the various Volterra monomials and solving a least squares regression problem to find the Volterra coefficients that best fit the digital pre-distortion output. In some embodiments, adaptive estimation techniques (e.g., LMS, RLS, etc.) are used to estimate the parameters of a digital pre-distortion model. In some embodiments, a band limiting operation is applied to the output of the Volterra model and the output of the mDPD circuit 202 prior to the estimation of model parameters.

In some embodiments, flow of operations 300 includes performing digital pre-distortion of the signal in operation 308. For example, the mDPD circuit 202 may receive the model parameters from the model estimator circuit 212 and apply the model to the signal prior to it being converted to a digital signal and amplified (e.g., by power amplifier 206).

With reference to FIG. 7, flow of operations 320 shows operations for performing digital pre-distortion of a signal using a bandlimited loopback, according to some embodiments. The operations of the flow of operations 320 may be performed by any of the circuits of the amplifying device 200.

In some embodiments, flow of operations 320 includes generating a digital loopback signal by sampling a loopback signal of an amplifier at a band limiting sampling frequency in operation 324. A band limiting frequency may refer to any frequency that does not support full bandwidth expansion caused by the nonlinearities of the power amplifier 206. The coupler 208 may direct a representation of the amplified signal back to the analog-to-digital converter 210. The analog-to-digital converter 210 may be configured to sample the loopback signal at a sampling frequency (e.g., 256 MHz, 512 MHz, etc.) to create a digital loopback signal by storing (e.g., saving) the samples in memory. In some embodiments, a demodulator circuit is disposed between the coupler 208 and the analog-to-digital converter 210 to translate the frequency content down from a carrier frequency to a baseband frequency. In some embodiments, an antialiasing filter is disposed between the coupler 208 and the analog-to-digital converter 210 to eliminate frequency content greater than the Nyquist frequency at the sampling rate of the analog-to-digital converter 210. The power amplifier 206 may introduce nonlinearities that cause frequency content to be generated outside of the bandwidth of the input signal (e.g., spectral regrowth). The methods described herein allow high digital pre-distortion performance without sampling at a high enough frequency that would allow all the frequency content of the power amplifier 206 output to be represented in the digital domain. For example, the digital loopback signal may be sampled at a frequency equal to the bandwidth of the original signal to be amplified or the digital loopback signal may be sampled at a frequency equal to twice the bandwidth of the original signal to be amplified.

In some embodiments, flow of operations 320 includes generating a band limited pre-distortion output signal by applying a band limiting operator to an output of the digital pre-distortion in operation 324. For example, operation 324 may be performed by the band limiting operator 240. A low pass filter may be applied. In some embodiments, the band limiting operation is applied by multiplying a vector including the outputs of the mDPD circuit 202 by a matrix representing the band limiting operation.

In some embodiments, flow of operations 320 includes generating a band limited pre-distortion output signal by applying a band limiting operation to each of a set of monomial expansion terms of the pre-distortion model in operation 326. For example, the band limiting operation 244 may be performed on the output of the monomial generators 220-226. A low pass filter may be applied. In some embodiments, the band limiting operation is applied by multiplying a matrix including monomial terms of a Volterra model by a matrix representing the band limiting operation. In some embodiments, the digital loopback signal is upsampled (e.g., samples are added between existing samples) prior to generating the expansion terms of the Volterra series (and prior to the band limiting operation). Performing upsampling, may mitigate (e.g., eliminate, reduce, etc.) aliasing that can occur from frequency components introduced by the nonlinear Volterra model (e.g., the mDPD model circuit 246).

In some embodiments, flow of operations 320 includes estimating parameters of a digital pre-distortion model using the digital loopback signal in operation 328. For example, the model estimator circuit 212 may generate a model (or parameters for a model) that estimates the bandlimited pre-distortion output of the mDPD circuit 202 from the output of the power amplifier 206, using a band limited output of the pre-distortion model (e.g., a band limiting operation applied to the output of a Volterra series model). The model generated may invert (e.g., negate, cancel, etc.) the nonlinear effect of the power amplifier 206. In some embodiments, the model is Volterra model that is estimated by generating a matrix of the various Volterra monomials and solving a least squares regression problem to find the Volterra coefficients that best fit the digital pre-distortion output. The band limiting operations may be represented by a matrix multiplication applied to both the Volterra terms and the output of the mDPD circuit 202 during the estimation procedure. In some embodiments, adaptive estimation techniques (e.g., LMS, RLS, etc.) are used to estimate the parameters of a digital pre-distortion model.

In some embodiments, flow of operations 320 includes performing digital pre-distortion of the signal in operation 330. For example, the mDPD circuit 202 may receive the model parameters from the model estimator circuit 212 and apply the model to the signal prior to it being converted to a digital signal and amplified (e.g., by power amplifier 206).

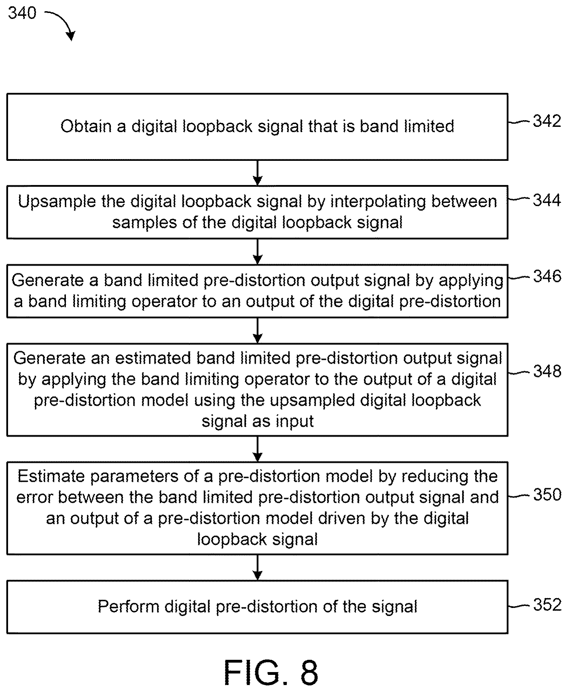

With reference to FIG. 8, flow of operations 340 shows operations for performing digital pre-distortion of a signal using a bandlimited loopback, according to some embodiments. The operations of the flow of operations 340 may be performed by any of the circuits of the amplifying device 200. In some embodiments, upsampling of a digital loopback signal and applying a band limiting operator to both the output of the digital pre-distortion and the digital pre-distortion model (or its individual components) are both performed to obtain maximized pre-distortion performance using a bandlimited loopback signal.

Flow of operations 340 may include obtaining a digital loopback signal that is band limited in operation 342. In some embodiments, the digital loopback signal is band limited because signal is sampled at a band limiting frequency. A band limiting frequency may refer to any frequency that does not support full bandwidth expansion caused by the nonlinearities of the power amplifier 206. In some embodiments, the digital loopback signal is band limited because of analog filtering in the loopback channel (e.g., a low pass filter or other band limiting effect may limit the feedback channel).

The coupler 208 may direct a representation of the amplified signal back to the analog-to-digital converter 210. The analog-to-digital converter 210 may be configured to sample the loopback signal at a sampling frequency (e.g., 256 MHz, 512 MHz, etc.) to create a digital loopback signal by storing (e.g., saving) the samples in memory. In some embodiments, a demodulator circuit is disposed between the coupler 208 and the analog-to-digital converter 210 to translate the frequency content down from a carrier frequency to a baseband frequency. In some embodiments, an antialiasing filter is disposed between the coupler 208 and the analog-to-digital converter 210 to eliminate frequency content greater than the Nyquist frequency at the sampling rate of the analog-to-digital converter 210.

In some embodiments, flow of operations 340 includes upsampling the digital loopback signal by interpolating between samples of the digital loopback signal in operation 344. The upsampler 248 may upsample the digital loopback signal by adding samples between the samples obtained by the analog-to-digital converter 210. Upsampling may be performed by storing new samples in between the records of existing samples, for example, if estimation is performed in a batch method (e.g., the pseudo-inverse described herein). Upsampling may also be performed by adding records within a stream of data (e.g., stored in RAM, registers, etc.). Various methods of interpolation may be used to perform upsampling. For example, linear interpolation, polynomial interpolation, spline interpolation, and/or trigonometric interpolation may be used. Any number of data points may be used to perform the interpolation and any number of samples may be on either side of the sample that is being generated (e.g., created, added, etc.). In some embodiments, the upsampler may perform extrapolation instead of interpolation (e.g., so that all samples of the upsampled signal up to the current time are known). Upsampling the digital loopback signal may allow for all frequency components that occur from the nonlinear operations of the mDPD model circuit 246 to be properly represented in the digital domain and may eliminate a potential aliasing effect.

In some embodiments, flow of operations 340 includes generating a band limited pre-distortion output signal by applying a band limiting operator to an output of the digital pre-distortion in operation 346. For example, operation 326 may be performed by the band limiting operator 240. A low pass filter may be applied. In some embodiments, the band limiting operation is applied by multiplying a vector including the outputs of the mDPD circuit 202 by a matrix representing the band limiting operation.

In some embodiments, flow of operations 340 includes generating an estimated band limited pre-distortion output signal by applying the band limiting operator to the output of a digital pre-distortion model using the upsampled digital loopback signal as input in operation 348. For example, band limiting operator 244 may be a low pass filter applied after the mDPD model circuit 246 prior to comparing to the band limited pre-distortion output signal by the parameter estimator 242. In some embodiments, the band limiting operation 244 is instead performed on the output of the monomial generators 220-226. The band limiting operation may be applied by multiplying a matrix including monomial terms of a Volterra model by a matrix representing the band limiting operation. In some embodiments, the digital loopback signal is upsampled (e.g., samples are added between existing samples) prior to generating the expansion terms of the Volterra series (and prior to the band limiting operation). Performing upsampling, may mitigate (e.g., eliminate, reduce, etc.) aliasing that can occur from frequency components introduced by the nonlinear Volterra model (e.g., the mDPD model circuit 246).

In some embodiments, flow of operations 340 includes estimating parameters of a digital pre-distortion model using the digital loopback signal in operation 350. For example, the model estimator circuit 212 may generate a model (or parameters for a model) that estimates the bandlimited pre-distortion output of the mDPD circuit 202 from the output of the power amplifier 206, using a band limited output of the pre-distortion model (e.g., a band limiting operation applied to the output of a Volterra series model). The model generated may invert (e.g., negate, cancel, etc.) the nonlinear effect of the power amplifier 206. In some embodiments, the model is Volterra model that is estimated by generating a matrix of the various Volterra monomials and solving a least squares regression problem to find the Volterra coefficients that best fit the digital pre-distortion output. The band limiting operations may be represented by a matrix multiplication applied to both the Volterra terms and the output of the mDPD circuit 202 during the estimation procedure. In some embodiments, adaptive estimation techniques (e.g., LMS, RLS, etc.) are used to estimate the parameters of a digital pre-distortion model.

In some embodiments, flow of operations 320 includes performing digital pre-distortion of the signal in operation 352. For example, the mDPD circuit 202 may receive the model parameters from the model estimator circuit 212 and apply the model to the signal prior to it being converted to a digital signal and amplified (e.g., by power amplifier 206).

## Configuration of Exemplary Embodiments

As utilized herein, the terms "approximately," "about," "substantially", and similar terms are intended to have a broad meaning in harmony with the common and accepted usage by those of ordinary skill in the art to which the subject matter of this disclosure pertains. It should be understood by those of skill in the art who review this disclosure that these terms are intended to allow a description of certain features described and claimed without restricting the scope of these features to the precise numerical ranges provided. Accordingly, these terms should be interpreted as indicating that insubstantial or inconsequential modifications or alterations of the subject matter described and claimed are considered to be within the scope of the disclosure as recited in the appended claims.

It should be noted that the term "exemplary" and variations thereof, as used herein to describe various embodiments, are intended to indicate that such embodiments are possible examples, representations, or illustrations of possible embodiments (and such terms are not intended to connote that such embodiments are necessarily extraordinary or superlative examples).

The construction and arrangement of the systems and methods as shown in the various exemplary embodiments are illustrative only. Although only a few embodiments have been described in detail in this disclosure, many modifications are possible (e.g., variations in port or destination quantity, data types, methods of reinsertion, reintroduction, etc., values of parameters, arrangements, etc.). For example, the position of elements may be reversed or otherwise varied, the connections between elements may be direct or indirect, such that there may be one or more intermediate elements connected in between, and the nature or number of discrete elements or positions may be altered or varied. Accordingly, all such modifications are intended to be included within the scope of the present disclosure. The order or sequence of any process or method steps may be varied or re-sequenced according to alternative embodiments. Other substitutions, modifications, changes, and omissions may be made in the design, operating conditions, and arrangement of the exemplary embodiments without departing from the scope of the present disclosure. For example, the embodiments of the present disclosure may be implemented by a single device and/or system or implemented by a combination of separate devices and/or systems.

The term "or," as used herein, is used in its inclusive sense (and not in its exclusive sense) so that when used to connect a list of elements, the term "or" means one, some, or all of the elements in the list. Conjunctive language such as the phrase "at least one of X, Y, and Z," unless specifically stated otherwise, is understood to convey that an element may be either X, Y, Z; X and Y; X and Z; Y and Z; or X, Y, and Z (i.e., any combination of X, Y, and Z). Thus, such conjunctive language is not generally intended to imply that certain embodiments require at least one of X, at least one of Y, and at least one of Z to each be present, unless otherwise indicated.

References herein to the positions of elements (i.e., "top," "bottom," "above," "below") are merely used to describe the orientation of various elements in the FIGURES. It should be noted that the orientation of various elements may differ according to other exemplary embodiments, and that such variations are intended to be encompassed by the present disclosure.

Although the figures show a specific order of method steps, the order of the steps may differ from what is depicted. Also two or more steps may be performed concurrently or with partial concurrence. Such variation will depend on the software and hardware systems chosen and on designer choice. All such variations are within the scope of the disclosure. Likewise, software implementations could be accomplished with standard programming techniques with rule-based logic and other logic to accomplish the various connection steps, processing steps, comparison steps, and decision steps.

The present disclosure contemplates methods, systems, and program products on any machine-readable media for accomplishing various operations. The embodiments of the present disclosure may be implemented using existing computer processors, or by a special purpose computer processor for an appropriate system, incorporated for this or another purpose, or by a hardwired system. Embodiments within the scope of the present disclosure include program products comprising machine-readable media for carrying or having machine-executable instructions or data structures stored thereon. Such machine-readable media can be any available media that can be accessed by a general purpose or special purpose computer or other machine with a processor. By way of example, such machine-readable media can comprise RAM, ROM, EPROM, EEPROM, CD-ROM or other optical disk storage, magnetic disk storage or other magnetic storage devices, or any other medium which can be used to carry or store desired program code in the form of machine-executable instructions or data structures and which can be accessed by a general purpose or special purpose computer (i.e., ASICs or FPGAs) or any other machine with a processor. Combinations of the above are also included within the scope of machine-readable media. Machine-executable instructions include, for example, instructions and data which cause a general purpose computer, special purpose computer, or special purpose processing machines to perform a certain function or group of functions.

The following are further embodiments of the invention:

1. A device comprising one or more circuits configured to perform operations comprising:

performing a digital pre-distortion of a signal;
generating a digital loopback signal by sampling a loopback signal of an amplifier at a band limiting sampling frequency;
upsampling the digital loopback signal by interpolating between samples of the digital loopback signal; and
estimating parameters of a digital pre-distortion model using the upsampled digital loopback signal.

2. The device of Embodiment 1, wherein interpolating between samples is performed using at least one of:

linear interpolation;

polynomial interpolation;
spline interpolation; or
trigonometric interpolation.

3. The device of Embodiment 1, wherein the band limiting sampling frequency is less than or equal to two times a bandwidth of the signal and a sampling frequency of the upsampled digital loopback signal is at least two times the band limiting sampling frequency.

4. The device of Embodiment 1, wherein the upsampled digital loopback signal reduces an aliasing effect of nonlinear terms of the digital pre-distortion model.

5. The device of Embodiment 1, wherein estimating the parameters of the digital pre-distortion model comprises reducing error between an output of the digital pre-distortion and an output of the digital pre-distortion model using the upsampled digital loopback signal as input.

6. The device of Embodiment 5, the operations further comprising:

generating a band limited pre-distortion output signal by applying a band limiting operator to the output of the digital pre-distortion; and
generating an estimated band limited pre-distortion output signal by applying the band limiting operator to the output of the digital pre-distortion model using the upsampled digital loopback signal as input,
wherein estimating the parameters of the digital pre-distortion model is performed by reducing error between the band limited pre-distortion output signal and the estimated band limited pre-distortion output signal.

7. The device of Embodiment 6, wherein the digital pre-distortion model comprises a Volterra series and the band limiting operator is applied to each of a plurality of monomial expansion terms of the Volterra series of the digital pre-distortion model.

8. The device of Embodiment 1, wherein a transmitter using the amplifier is not bandlimited between the amplifier and a coupler used to generate the loopback signal.

9. A device comprising one or more circuits configured to perform operations comprising:

performing a digital pre-distortion of a signal;
generating a digital loopback signal by sampling a loopback signal of an amplifier at a band limiting sampling frequency;
generating a band limited pre-distortion output signal by applying a band limiting operator to an output of the digital pre-distortion; and
estimating parameters of a digital pre-distortion model by reducing error between the band limited pre-distortion output signal and an output of the digital pre-distortion model using the digital loopback signal as input, wherein the band limiting operator is applied to each of a plurality of monomial expansion terms of the digital pre-distortion model.

10. The device of Embodiment 9, wherein estimating the parameters of the digital pre-distortion model is performed using a least squares estimation technique.

11. The device of Embodiment 9, wherein the plurality of monomial expansion terms comprises terms from a discrete Volterra series.

12. The device of Embodiment 9, wherein a transmitter using the amplifier is not bandlimited between the amplifier and a coupler used to generate the loopback signal.

13. The device of Embodiment 9, the operations further comprising upsampling the digital loopback signal to reduce an aliasing effect of nonlinear terms of the digital pre-distortion model.

14. The device of Embodiment 13, wherein the band limiting sampling frequency is less than or equal to two times a bandwidth of the signal a sampling frequency of the upsampled digital loopback signal is at least two times the band limiting sampling frequency.

15. A device comprising one or more circuits configured to perform operations comprising:

performing a digital pre-distortion of a signal;
acquiring a digital loopback signal by sampling a loopback signal of an amplifier;
generating a band limited pre-distortion output signal by applying a band limiting operator to an output of the digital pre-distortion of the signal;
upsampling the digital loopback signal by interpolating between samples of the digital loopback signal;
generating an estimated band limited pre-distortion output signal by applying the band limiting operator to the output of a digital pre-distortion model using the upsampled digital loopback signal as input; and
estimating parameters of the digital pre-distortion model by reducing error between the band limited pre-distortion output signal and the estimated band limited pre-distortion output signal.

16. The device of Embodiment 15, wherein estimating the parameters of the digital pre-distortion model is performed using a least squares estimation technique.

17. The device of Embodiment 16, wherein the digital pre-distortion model comprises a plurality of monomial expansion terms, and
wherein generating an estimated band limited pre-distortion output comprises applying the band limiting operator to each of the plurality of monomial expansion terms.

18. The device of Embodiment 15, wherein applying the band limiting operator reduces frequencies outside a frequency band of the signal.

19. The device of Embodiment 15, wherein interpolating between samples is performed using at least one of:

linear interpolation;
polynomial interpolation;
spline interpolation; or
trigonometric interpolation.

20. The device of Embodiment 15, wherein a sampling frequency of the upsampled digital loopback signal is at least two times the sampling frequency of the digital loopback signal.

**Claims**

1. A device comprising one or more circuits configured to perform operations comprising:

performing a digital pre-distortion of a signal;
generating a digital loopback signal by sampling a loopback signal of an amplifier at a band limiting sampling frequency;
upsampling the digital loopback signal by interpolating between samples of the digital loopback signal; and
estimating parameters of a digital pre-distortion model using the upsampled digital loopback signal.

2. The device of claim 1, wherein the band limiting sampling frequency is less than or equal to two times a bandwidth of the signal and a sampling frequency of the upsampled digital loopback signal is at least two times the band limiting sampling frequency.

3. The device of claim 1 or 2, wherein the upsampled digital loopback signal reduces an aliasing effect of nonlinear terms of the digital pre-distortion model.

4. The device of any preceding claim, wherein estimating the parameters of the digital pre-distortion model comprises reducing error between an output of the digital pre-distortion and an output of the digital pre-distortion model using the upsampled digital loopback signal as input.

5. The device of claim 4, the operations further comprising:

generating a band limited pre-distortion output signal by applying a band limiting operator to the output of the digital pre-distortion; and
generating an estimated band limited pre-distortion output signal by applying the band limiting operator to the output of the digital pre-distortion model using the upsampled digital loopback signal as input,
wherein estimating the parameters of the digital pre-distortion model is performed by reducing error between the band limited pre-distortion output signal and the estimated band limited pre-distortion output signal,
in particular, wherein the digital pre-distortion model comprises a Volterra series and the band limiting operator is applied to each of a plurality of monomial expansion terms of the Volterra series of the digital pre-distortion model.

6. A device comprising one or more circuits configured to perform operations comprising:

performing a digital pre-distortion of a signal;
generating a digital loopback signal by sampling a loopback signal of an amplifier at a band limiting sampling frequency;
generating a band limited pre-distortion output signal by applying a band limiting operator to an output of the digital pre-distortion; and
estimating parameters of a digital pre-distortion model by reducing error between the band limited pre-distortion output signal and an output of the digital pre-distortion model using the digital loopback signal as input, wherein the band limiting operator is applied to each of a plurality of monomial expansion terms of the digital pre-distortion model.

7. The device of claim 6, wherein estimating the parameters of the digital pre-distortion model is performed using a least squares estimation technique, and/or
wherein the plurality of monomial expansion terms comprises terms from a discrete Volterra series.

8. The device of claim 6 or 7, the operations further comprising upsampling the digital loopback signal to reduce an aliasing effect of nonlinear terms of the digital pre-distortion model,
in particular, wherein the band limiting sampling frequency is less than or equal to two times a bandwidth of the signal a sampling frequency of the upsampled digital loopback signal is at least two times the band limiting sampling frequency.

9. The device of any preceding claim, wherein a transmitter using the amplifier is not bandlimited between the amplifier and a coupler used to generate the loopback signal.

10. A device comprising one or more circuits configured to perform operations comprising:

performing a digital pre-distortion of a signal;
acquiring a digital loopback signal by sampling a loopback signal of an amplifier;
generating a band limited pre-distortion output signal by applying a band limiting operator to an output of the digital pre-distortion of the signal;
upsampling the digital loopback signal by interpolating between samples of the digital loopback signal;
generating an estimated band limited pre-distortion output signal by applying the band limiting operator to the output of a digital pre-distortion model using the upsampled digital loopback signal as input; and
estimating parameters of the digital pre-distortion model by reducing error between the band limited pre-distortion output signal and the estimated band limited pre-distortion output signal.

11. The device of claim 10, wherein estimating the parameters of the digital pre-distortion model is performed using a least squares estimation technique.

12. The device of claim 11, wherein the digital pre-distortion model comprises a plurality of monomial expansion terms, and
wherein generating an estimated band limited pre-distortion output comprises applying the band limiting operator to each of the plurality of monomial expansion terms.

13. The device of any of claims 10 to 12, wherein applying the band limiting operator reduces frequencies outside a frequency band of the signal.

14. The device of any of claims 10 to 13, wherein a sampling frequency of the upsampled digital loopback signal is at least two times the sampling frequency of the digital loopback signal.

**15.** The device of any of claims 1 to 5 and 10 to 14, wherein interpolating between samples is performed using at least one of:

linear interpolation;
polynomial interpolation;
spline interpolation; or
trigonometric interpolation.

FIG. 1A

FIG. 1B

FIG. 1C

200

Signal $x[n]$ → mDPD (202) → Digital Pre-distortion output $z[n]$ → D/A (204) → Power Amplifier (206) → 208

Pre-distortion model parameters $d$

Model Estimator (212) → Digital Loopback Signal $y[n]$ ← A/D (210) ← Loopback signal $y(t)$

## FIG. 2

202

Signal $x[n]$

Monomial Generator p=0, k=0 (220) → Memory Elements $c_{m0}$ m=0-M (230)

Monomial Generator p=1, k=0 (222) → Memory Elements $c_{m1}$ m=0-M (232)

Monomial Generator p=P, k=0 (224) → Memory Elements $c_{mP}$ m=0-M (234)

Monomial Generator p=P, k=$K_3$ (226) → Memory Elements $c_{KmP}$ m=0-M (236)

→ Σ → Digital Pre-distortion output $z[n]$

## FIG. 3

Pre-distortion
output $z[n']$

240

Band Limiting
Operator

to mDPD

212

Band Limited
Pre-distortion
output $h[n']$

242

Pre-distortion model
parameters $c$

Parameter
Estimator

Estimated Band
Limited Pre-distortion
output $\hat{h}[n']$

246

248

mDPD
model

Upsampler

Upsampled
Digital Loopback
Signal $y'[n']$

Digital Loopback
Signal $y[n]$

FIG. 4A

220

Monomial Generator
p=0, k=0

244

BL

230

Memory Elements
$c_{m0}$ m=0-M

246

222

Monomial Generator
p=1, k=0

244

BL

232

Memory Elements
$c_{m0}$ m=0-M

Σ

224

Monomial Generator
p=P, k=0

244

BL

234

Memory Elements
$c_{mP}$ m=0-M

Estimated
Band Limited
Pre-distortion
output $\hat{h}[n']$

226

Monomial Generator
p=P, k=K₃

244

BL

236

Memory Elements
$c_{KmP}$ m=0-M

FIG. 4B

Pre-distortion output $z[n']$

240

Band Limiting Operator

to mDPD

212

Band Limited Pre-distortion output $h[n']$

242

Parameter Estimator

Pre-distortion model parameters $c$

Bandlimited Model Terms

246

mDPD model

248

Upsampler

Upsampled Digital Loopback Signal $y'[n']$

Digital Loopback Signal $y[n]$

## FIG. 5A

246

220

Monomial Generator p=0, k=0

244

BL

230

Memory Elements $c_{m0}$ m=0-M

222

Monomial Generator p=1, k=0

244

BL

232

Memory Elements $c_{m0}$ m=0-M

224

Monomial Generator p=P, k=0

244

BL

234

Memory Elements $c_{mP}$ m=0-M

Bandlimited Model Terms

226

Monomial Generator p=P, k=$K_3$

244

BL

236

Memory Elements $c_{KmP}$ m=0-M

## FIG. 5B

300 —

| Generate a digital loopback signal by sampling a loopback signal of an amplifier at a band limiting sampling frequency | —302 |

↓

| Upsample the digital loopback signal by interpolating between samples of the digital loopback signal | —304 |

↓

| Estimate parameters of a digital pre-distortion model using the upsampled digital loopback signal | —306 |

↓

| Perform digital pre-distortion of the signal | —308 |

# FIG. 6

320 —

| Generate a digital loopback signal by sampling a loopback signal of an amplifier at a band limiting sampling frequency | —322 |

↓

| Generate a band limited pre-distortion output signal by applying a band limiting operator to an output of the digital pre-distortion | —324 |

↓

| Apply a band limiting operation to each of a set of monomial expansion terms of the pre-distortion model | —326 |

↓

| Estimate parameters of a pre-distortion model by reducing the error between the band limited pre-distortion output signal and an output of a pre-distortion model driven by the digital loopback signal | —328 |

↓

| Perform digital pre-distortion of the signal | —330 |

# FIG. 7

340 ⌐

```
┌─────────────────────────────────────────────────────────┐
│                                                         │
│      Obtain a digital loopback signal that is band limited │──342
│                                                         │
└─────────────────────────────────────────────────────────┘
                            │
                            ▼
┌─────────────────────────────────────────────────────────┐
│  Upsample the digital loopback signal by interpolating between │──344
│            samples of the digital loopback signal        │
└─────────────────────────────────────────────────────────┘
                            │
                            ▼
┌─────────────────────────────────────────────────────────┐
│  Generate a band limited pre-distortion output signal by applying │──346
│  a band limiting operator to an output of the digital pre-distortion │
└─────────────────────────────────────────────────────────┘
                            │
                            ▼
┌─────────────────────────────────────────────────────────┐
│  Generate an estimated band limited pre-distortion output signal │
│   by applying the band limiting operator to the output of a digital │──348
│        pre-distortion model using the upsampled digital loopback │
│                     signal as input                     │
└─────────────────────────────────────────────────────────┘
                            │
                            ▼
┌─────────────────────────────────────────────────────────┐
│  Estimate parameters of a pre-distortion model by reducing the │
│  error between the band limited pre-distortion output signal and │──350
│       an output of a pre-distortion model driven by the digital │
│                     loopback signal                     │
└─────────────────────────────────────────────────────────┘
                            │
                            ▼
┌─────────────────────────────────────────────────────────┐
│           Perform digital pre-distortion of the signal   │──352
└─────────────────────────────────────────────────────────┘
```

# FIG. 8

FIG. 9

EP 4 738 702 A1

FIG. 10

# EUROPEAN SEARCH REPORT

**Application Number**

EP 25 20 8506

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/028476 A1 (KIM HELEN H [US] ET AL) 23 January 2020 (2020-01-23) * paragraphs [0005], [0060], [0061]; figure 4 * ----- | 1-15 | INV. H03F1/32 H03F3/189 H03F3/24 |
| A | US 2020/382147 A1 (MENKHOFF ANDREAS [DE] ET AL) 3 December 2020 (2020-12-03) * paragraphs [0139] - [0150]; figure 23 * ----- | 1-15 | |

**TECHNICAL FIELDS SEARCHED (IPC)**

H03F

The present search report has been drawn up for all claims

| Place of search | Date of completion of the search | Examiner |
|---|---|---|
| The Hague | 23 March 2026 | Goethals, Filip |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 8506

This annex lists the patent family members relating to the patent documents cited in the above-mentioned European search report.
The members are as contained in the European Patent Office EDP file on
The European Patent Office is in no way liable for these particulars which are merely given for the purpose of information.

23-03-2026

| Patent document cited in search report | Publication date | Patent family member(s) | | Publication date |
|---|---|---|---|---|
| US 2020028476 A1 | 23-01-2020 | CN | 110574288 A | 13-12-2019 |
| | | EP | 3586439 A1 | 01-01-2020 |
| | | JP | 2020511822 A | 16-04-2020 |
| | | KR | 20190121825 A | 28-10-2019 |
| | | US | 2020028476 A1 | 23-01-2020 |
| | | WO | 2018156932 A1 | 30-08-2018 |
| US 2020382147 A1 | 03-12-2020 | CN | 111436225 A | 21-07-2020 |
| | | CN | 116708099 A | 05-09-2023 |
| | | EP | 3701691 A1 | 02-09-2020 |
| | | US | 2020382147 A1 | 03-12-2020 |
| | | US | 2022368360 A1 | 17-11-2022 |
| | | WO | 2019132949 A1 | 04-07-2019 |